# EUROPÄISCHE PATENTSCHRIFT

(11) **EP 3 433 883 B1**
(45) Veröffentlichungstag und Bekanntmachung des Hinweises auf die Patenterteilung: **22.04.2020**
(21) Anmeldenummer: 17723248.5
(22) Anmeldetag: 08.03.2017
(51) Int. Cl.: H01L 51/40, H01L 51/10, G11C 13/00

(54) **VERFAHREN ZUR HERSTELLUNG EINES SPEICHERS, SPEICHER SOWIE VERWENDUNG DES SPEICHERS**
METHOD FOR FABRICATION OF A MEMORY, MEMORY, AND THE USE OF THE SAID MEMORY
PROCÉDÉ DE FABRICATION D'UNE MÉMOIRE, MÉMOIRE ET UTILISATION DE LA MÉMOIRE

(30) Priorität: 23.03.2016 DE 102016003461; 01.04.2016 DE 102016003770
(43) Veröffentlichungstag der Anmeldung: 30.01.2019
(73) Patentinhaber: Forschungszentrum Jülich GmbH, 52425 Jülich (DE)
(72) Erfinder: YAKUSHENKO, Alexey, 52068 Aachen (DE); FUNARI, Riccardo, 80124 Napoli (IT); KRAUSE, Kay Johannes, 41836 Hückelhoven (DE); SCHNITKER, Jan Hendrik, 47803 Krefeld (DE); MAYER, Dirk, 50226 Frechen (DE); ADLY HASSAN, Nouran Yehia, 81925 München (DE); OFFENHÄUSSER, Andreas, 52064 Aachen (DE)
(86) Internationale Anmeldenummer: PCT/DE2017/000063
(87) Internationale Veröffentlichungsnummer: WO 2017/162222

(56) Entgegenhaltungen:
- WO-A2-2014/061018
- US-A1- 2014 061 757
- US-B1- 7 307 338

## Beschreibung

Die Erfindung bezieht sich auf ein Verfahren zur Herstellung eines Speichers, einen Speicher sowie die Verwendung des Speichers.

### Stand der Technik

US 7,307,338 B1 offenbart eine Polymerspeicherzelle auf einem Wafersubstrat.

US 2014/061757 A1 offenbart eine Halbleiterstruktur sowie ein Verfahren zu seiner Herstellung.

Im Stand der Technik sind nicht-volatile Speichertechniken bekannt, die in großem Umfang in informationsverarbeitenden, elektronischen Gerätschaften oder zur Warenkennzeichnung eingesetzt werden.

Es gibt einen kommerziell sehr weit verbreiteten 1-Bit ROM/WORM Speicher, der in Form einer LC-Schwingkreis-Schaltung etabliert ist. Der Schwingkreis hat eine durch die Bauteileparameter festgelegte Eigenfrequenz. Eine Testwelle kann durch die Energieabsorption des Schwingkreises eine Ja/Nein-Information ermitteln. Solche Tags sind sehr kostengünstig und können durch Anlegen eines starken Magnetfeldes leicht ausgeschaltet bzw. zerstört werden (1 Bit ROM/ WORM Speicher).

Die Speichertechniken für komplexere informationsverarbeitende, elektronische Gerätschaften beruhen hingegen in sehr hohem Maße auf der Benutzung von Silizium-Technologie (CMOS), um diese Speicher herzustellen. Aktuell in Benutzung befindliche nicht-flüchtige Speicher benutzen festkörperphysikalische Eigenschaften, um eine Information speichern zu können und auch über lange Zeiträume (>10 Jahre) ohne externe Energieversorgung vorhalten zu können.

### EPROMs / EEPROMs / Flash-EPROMs:

Ein Klasse von Speicherbausteinen, die auf Silizium-Halbleitertechnologie beruht. Das Grundelement von EPROMs/EEPROMs und Flash-EPROMs ist ein MOSFET (Feldeffekt-Transistor) mit einer allseitig isolierten Gateelektrode. Die Isolation wird durch eine Schicht SiO₂ realisiert. Eine auf die Gateelektrode aufgebrachte Ladung wird über das isolierende, als Dielektrikum wirkende SiO₂ dauerhaft gehalten und sperrt gegebenenfalls den Transistor.

EPROM: Dieser Speichertyp ist elektrisch beschreibbar und auslesbar. Bevor eine elektrische Wiederbeschreibung erfolgen kann, muss eine Bestrahlung des Speicherchips mit UV erfolgen. Dieser Grundtyp wird über die FAMOS (floating gate avalanche injection MOS) Zelle realisiert, wobei ein p-Kanal MOSFET eingesetzt wird, oder über einen n-Kanal-MOSFET, der neben einem Floating Gate ein Steuergate besitzt. Die Beschreibung erfolgt über hot carrier injection (HCl), was ausnutzt, dass Elektronen mit genügend kinetischer Energie eine Potentialbarriere durchbrechen können und auf dem Gate gespeichert werden.

Die Speicherzelle muss für eine Wiederbeschreibung mit UV bestrahlt werden. Photonen mit ausreichender kinetischer Energie, abhängig vom Gatematerial, regen die Elektronen des Floating Gates an, so dass diese das Gate verlassen können. Die Löschdauer beträgt in der Größenordnung von 10 Minuten und erfordert das mechanische Verschieben eines Blendschutzes der Speicherzelle mit Quarzglas-Fenster, der im Normalbetrieb/Lesemodus abgedeckt sein muss.

Die Schreibenergie beträgt ∼1µJ / Bit. Die Schreibzeit beträgt ∼ 3 - 50 ms, + 10 Minuten bei Wiederbeschreibung. Die Betriebsspannung liegt bei 3-6 V und die Schreibspannung bei ∼12 V.

### EEPROM (auch E²PROM):

Der Electrically Erasable PROM (EEPROM) ist eine Speicherzelle, die sowohl elektrisch gelesen als auch elektrisch geschrieben werden kann. Die auf das Gate aufgebrachte Ladung wird über den quantenphysikalischen Tunneleffekt erreicht. Der Schreib/Lösch-Modus verläuft daher über Feldemission (Fowler-Nordheim Tunneling) unter Anlegung eines hohen elektrischen Feldes und erfolgt bit-weise.

Typische Speicherkapazitäten liegen bei 1 - 4 Mbit. Die Schreibenergie beträgt ∼1µJ/Bit. Die Schreibzeit beträgt ∼1-10 ms und die Betriebsspannung: 3-6 V. Marktführer für RFID EEPROM ist Atmel, USA. Der Vertrieb läuft z. B. über das Handelsprodukt ATA5575M1 16 Byte EEPROM Microcontroller.

### Flash-EPROM (auch "Flash-Speicher"):

Der Aufbau dieser Speicherzelle basiert auf der EPROM Technologie. Bei diesem Speicher-Typ wird die Ladung über das hot carrier injection Verfahren auf das Gate aufgebracht und der Schreib-/Löschvorgang über Fowler-Nordheim-Tunneling erreicht (wie bei EEPROM). Große Mengen von Speicherzellen werden als Matrix angeordnet und sind in zwei Architekturformen NAND-Flash und NOR-Flash weit kommerzialisiert. Durch die Matrixarchitektur und Nutzung gemeinsamer Zweige für Source/Drain ist eine vollständige Schaltung einzelner Bits nicht möglich. Insbesondere das Löschen eines Zustandes kann nur Blockweise erfolgen.

Die typischen Speicherkapazitäten liegen bei 1 MBit - 128 GBit. Die Schreibenergie liegt bei ∼1µJ/Bit, die Schreibzeit beträgt ∼ 0,1 - 1 ms. Die Betriebsspannung liegt bei 3 - 6 V, 12 V.

### MLC NAND (Multi-Level-Cell Flash) Speicher:

Dieser Speichertyp ist an die Flash-Speicher angelehnt, welche nur 1 Bit pro Zelle speichern können, und kann mehrere Bit pro Zelle speichern. Die höhere Speicherdichte wird erreicht indem man mehrere Ladungszustände pro Transistor unterscheidet. Die MLC-Speicher erreichen heutzutage bis zu 4-bit, wobei 16 Ladungszustände unterschieden werden. Typische Strukturgrößen für einen Transistor mit diesem Speichertyp liegen bei 10 - 20 nm. Marktführer in diesem Segment sind SanDisk und Samsung.

### Ferroelectric RAM (FRAM oder FeRAM):

FRAM basiert ebenfalls auf Silizium Halbleitertechnologie. Auf dem Gate eines Feldeffekt-Transistors wird ein ferroelektrischer Kristall aufgebracht, der durch Anlegen eines Feldes polarisiert werden kann und den Transistor schaltet. Die Schreibenergie beträgt ∼0,1 µJ/Bit. Die Schreibzeit liegt bei ∼1-10 µs. Die Betriebsspannung liegt bei 1-3 V. Marktführer für RFID FRAM ist Fujitsu, Japan.

Für drahtlos auslesbare Speicher, die als RW RFID/NFC Tag etabliert sind und mehr als >1 Bit Speicher aufweisen, werden insbesondere EEPROM und FRAM Speicher benutzt (Marktführer NXP).

Für gedruckte RFID/NFC Tags gibt es bisher wenige kommerzielle Produkte. Der bekannteste Ansatz ist der von der Firma Thin Film Electronics ASA. Dort wird ein gedruckter, nicht-volatiler Speicher auf Basis von ferroelektrischen Polymeren genutzt. In diesen Speicherzellen wird das ferroelektrische Polymer zwischen zwei Elektroden in eine passive Matrix eingelegt. So wird auf jedem Kreuzungspunkt der leitenden metallischen Kontaktlinien ein ferroelektrischer Kondensator geformt, der eine Speicherzelle definiert.

Es sind elektrochemische Speicher bekannt. So z. B. ein elektrochemischer Metallisierungsspeicher (electrochemical metallization memory, ECM) oder generell Memristor-Vorrichtungen. Diese basieren meistens auf einem elektrochemischen Verfahren wie aus Valov et al. bekannt ist (Ilia Valov, Rainer Waser, John R. Jameson and Michael N Kozicki, 2011. Electrochemical metallization memories: fundamentals, applications, prospects. Nanotechnology 22, 254003 (22pp) doi: 10.1088/0957-4484/22/25/254003).

Das Wirkungsprinzip des ECMs ist das eines elektrochemischen Memristors. Ein Memristor ist ein passives elektronisches Bauelement, dessen elektrischer Widerstand nicht konstant ist, sondern von seiner Vergangenheit abhängt. Der aktuelle Widerstand dieses Bauelements ist davon abhängig, wie viele Ladungen in der Vergangenheit in welche Richtung geflossen sind. Damit ist der Widerstandswert über den zeitlichen Verlauf des Stroms einstellbar. Dieser Widerstand bleibt auch ohne Energiezufuhr dauerhaft erhalten. Zwischen den Elektroden einer Speicherzelle befindet sich ein Elektrolyt aus Metallsalzen oder Metalloxiden, manchmal flüssig aber meistens fest. Wenn zwischen den Elektroden ein reduzierendes Potential angelegt wird, reduzieren sich Metall-Kationen in elementares Metall und formen Fasern, sogenannte Filamente, von der Arbeitselektrode zu der Gegenelektrode, die eine leitende Verbindung zwischen den Elektroden herstellen. Bei Anlegung des umgekehrten oxidierenden Potentials, oxidieren die Metalle und lösen diese Fasern wieder auf. Wenn beide Elektroden durch eine leitende Faser überbrückt sind kann der Strom mit geringem Widerstand fließen und die Speicherzelle weist den Zustand "1" auf. Wenn die Elektrode in der Zelle nicht durch Fasern verbunden sind, ist der Widerstand groß und die Speicherzelle steht auf "0".

Der Stand der Technik weist die folgenden Nachteile auf:
Der Nachteil von LC Schwingkreisen ist die Begrenzung der Speicherkapazität auf 1 Bit.

EEPROM und FRAM sind beide auf Grund der benötigten Siliziumhalbleitertechnologie teuer in der Herstellung (z. B. ∼0,5-1,0 € pro RFID-Tag). Außerdem ist die zum Schalten benötigte Energie gerade beim EEPROM sehr hoch. Da bei der Nutzung als RFID nur ca. 1/1000 der zum Auslesen eingesetzten Energie von der Tag-Antenne aufgenommen werden kann, ist die Reichweite und Leitungsfähigkeit durch den Energiebedarf der Speicherzelle begrenzt.

FRAM hingegen ist zwar energiesparender, aber auf Grund der komplexeren Herstellung und der benötigten ferroelektrischen Kristallstruktur noch deutlich teurer als EEPROM. Diese Verfahren sind wirtschaftlich wenn überhaupt nur dann rentabel, wenn eine sehr hohe Integrationsdichte und hohe absolute Speichermengen hergestellt werden können. Speichermengen im Bereich von einigen Bit bis in den Megabit-Bereich sind ökonomisch aber mit dieser Technologie nicht realisierbar, da die Grundkosten bei dieser Technologie bereits sehr hoch sind.

Elektrochemische Metallisierungsspeicher werden durch photolithographische Verfahren zur Mikro- und Nanostrukturierung hergestellt. Diese Verfahren sind ebenfalls per se aufwändig und damit teuer.

Nachteilig sind die bisher veröffentlichten Verfahren zur Herstellung nicht volatiler Speicher aufwändig und damit Zeit- und/oder kostenintensiv.

### Aufgabe der Erfindung

Aufgabe der Erfindung ist es einen neuartigen Speicher bereit zu stellen, der die Nachteile aus dem Stand der Technik nicht aufweist. Ferner ist es eine Aufgabe der Erfindung ein Verfahren zur Herstellung des Speichers bereit zu stellen und Verwendungen hierzu aufzuzeigen.

### Lösung der Aufgabe

Die Aufgabe wird gelöst mit dem Verfahren nach dem Patentanspruch 1 und dem Speicher und der Verwendung des Speichers gemäß des Nebenanspruchs. Vorteilhafte Ausgestaltungen hierzu ergeben sich jeweils aus den hierauf rückbezogenen Patentansprüchen.

### Beschreibung der Erfindung

Das erfindungsgemäße Verfahren zur Herstellung eines elektrochemischen Speichers ist gekennzeichnet durch die Schritte:
a) ein nicht leitendes Substrat wird bereit gestellt;
b) eine erste Leiterbahn aus leitendem Material wird auf dem Substrat angeordnet;
c) auf die erste Leiterbahn wird punktförmig eine Sol-Gel-Tinte oder eine HydrogelTinte für ein poröses Dielektrikum angeordnet und derart getrocknet, dass eine nanoporöse Schicht mit Poren umfassend ein Flüssigkeitsvolumen ausgebildet wird, welches redoxaktive Moleküle aufweist;
d) orthogonal oder mit einem Winkel von 5 - 90 Grad zur ersten Leiterbahn wird eine zweite Leiterbahn angeordnet, wobei am Kreuzungspunkt die Leiterbahnen eine Elektrodenfunktion aufweisen, zwischen denen das Dielektrikum angeordnet wird; dies erlaubt die spannungsgetriebene Redoxreaktion der redoxaktiven Moleküle an den Elektroden.
e) auf das Substrat, die erste Leiterbahn, das Dielektrikum und die zweite Leiterbahn wird eine Passivierungsschicht angeordnet.

Es können zusätzliche Passivierungsschichten zur Passivierung der Leiterbahnen angeordnet werden. Mit Ausnahme des Dielektrikums kann z. B. auch die Struktur im Anschluss von Schritt c) optional passiviert werden durch Anordnung einer Passivierungsschicht.

Anders als für redoxaktive Sensoren gibt es also mit Ausnahme der Kontaktstellen am Ende der Leiterbahnen keine Zugänge an den Elektroden, sondern es handelt sich um ein vollständig abgeschlossenes System ohne Leckströme und/oder Verdampfung der redoxaktiven Moleküle.

Erfindungsgemäß bilden die erste und die zweite Leiterbahn an ihrem Kreuzungspunkt mit dem dazwischen angeordneten Dielektrikum einen nicht volatilen 1 Bit Speicher aus, in dem durch Anlegen von Spannung über die Leiterbahnen die Redoxreaktion der redoxaktiven Moleküle an den Elektroden getrieben wird.

Als elektrisch nicht leitendes Substrat kann Glas, Siliziumoxid bzw. Polymere, und so weiter verwendet werden.

Als Material für die erste Leiterbahn bzw. Elektrode kann z. B. Gold, Platin, Kohlenstoff, leitfähige Polymere und so weiter verwendet werden.

Es kann eine Vielzahl an Leiterbahnen vorzugsweise orthogonal zueinander angeordnet werden. Dann wird vorteilhaft eine "crossbar"-Struktur bereitgestellt.

Die erste(n) Leiterbahn(en) werden vorzugsweise mittels Tintenstrahldruckverfahren oder anderem Druckverfahren in einer fertigen Strukturierung aufgetragen. Dies reduziert vorzugsweise die Kosten bei der Herstellung der Speicher.

Ein Druckverfahren, vor allem Digitaldruckverfahren wie Tintenstrahldruck oder Aerosol-Jet Druck, ist vorteilhaft schnell, preiswert, sowie sehr gut reproduzierbar. Außerdem ermöglicht das digitale Verfahren eine Anordnung unterschiedlicher Tinten, bzw. Tinten mit unterschiedlichen Konzentrationen der Redoxmoleküle, punktförmig auf den Kreuzpunkten, was für den Speicher besonders vorteilhaft ist.

Das Verfahren zur Herstellung des Redox-Cycling-Speichers umfasst somit insbesondere aber nicht ausschließlich eine Wahl leitfähiger und/oder isolierender, insbesondere druckbarer Partikel, mit denen die Leiterbahnen bzw. Elektroden und/oder das Dielektrikum strukturiert übereinander angeordnet werden können. Insbesondere aber nicht ausschließlich wird Tintenstrahldruck, Aerosol Jet-Verfahren, Siebdruck, Gravurdruck, Offset-Druck, Mikrokontaktdruck, Nanoimprintdruck oder Heißprägen angewendet. Es können Kombinationen aus Beschichtungs- und Abtragungsschritten, die gleiche Schichten aufbringen in Kombination mit verschiedenen Beschichtungsverfahren wie z. B. Slot-die, Laserabtragung und so weiter durchgeführt werden. Insbesondere wird ausschließlich Tintenstrahldruck verwendet, da es ein besonders preiswertes Verfahren ist.

Die erste Leiterbahn weist entweder keine oder nur sehr kleine Poren im Vergleich zum darüber anzuordnenden Dielektrikum auf. Die Leiterbahn muss entsprechend leitend, chemisch inert sein und geringer Ladungstransferwiderstand und damit gute elektrochemische Eigenschaften aufweisen. Dadurch wird vorteilhaft bewirkt, dass störungsfreie zyklische Voltammograme mit Standard-Redox-Molekülen gemessen werden können.

Im Falle des Tintenstrahldrucks sollte die Tinte nach dem Druck auf das Substrat vorzugsweise gesintert werden. Hierzu können thermische, photonische, UV oder andere Sinterverfahren durchgeführt werden, damit sich eine homogene leitende Schicht für die erste Leiterbahn bildet.

Im Anschluss wird eine dielektrische Tinte auf den zukünftigen Kreuzungspunkt gedruckt. Als Tinte verwendet man vorzugsweise ein Sol-Gel oder Hydrogel und optional enthält die Tinte auch bereits Redox-Moleküle als aktives Material und bildet später das nanoporöse Dielektrikum.

Die Tinte kann zusätzlich andere Additive wie Weichpolymere für erhöhte Elastizität sowie Stoffe, die die Druckeigenschaften der Tinten verbessern, beinhalten.

Die Tinte soll, bevor die nächste leitende obere Leiterbahn bzw. Elektrode gedruckt wird, aushärten aber nicht austrocknen. Im Falle von Sol-Gel-basierter Tinte bedeutet dies, dass die Kondensationsreaktion des Sol-Gels stattfinden soll. Die durch die Sol-Gel-Reaktion geformten Poren sind in einer Ausgestaltung der Erfindung kleiner, als die Partikel für die leitende Tinte der oberen Leiterbahn bzw. Elektrode.

Hieran anschließend wird die zweite Leiterbahn vorzugsweise aus einer leitenden Tinte orthogonal zu der unteren Leiterbahn gedruckt, sodass am Kreuzungspunkt der oberen Leiterbahn und der unteren Leiterbahn die Leiterbahnen Elektrodenfunktion wahrnehmen können. Vorzugsweise werden in "crossbar"-Strukturen eine Vielzahl an zweiten Leiterbahnen orthogonal zu den ersten Leiterbahnen angeordnet.

An den jeweiligen Kreuzungspunkten der unteren, ersten Leiterbahnen zu den oberen, zweiten Leiterbahnen ist in "Sandwich"-Struktur die nanoporöse dielektrische Schicht jeweils eingeschlossen, die damit die Speicher-Matrix formt.

Im Falle eines Tintenstrahldrucks soll die Tinte für die zweite(n) Leiterbahn(en) Nanopartikel vorzugsweise aus Gold, Platin, Kohlenstoff, leitfähige Polymere und so weiter umfassen. Die Nanopartikelgröße für die Tinte der zweiten Leiterbahn soll dann nicht kleiner sein, als die Poren in der darunterliegenden dielektrischen Schicht, damit die Nanopartikel zum Aufbau der zweiten Leiterbahn nicht in die Zwischenschicht, das Dielektrikum eindringen und einen Kurzschluss zwischen den Elektroden verursachen können. Auch diese Tinte sollte vorzugsweise gesintert werden, z. B. thermisch, photonisch, durch UV oder ein anderes Verfahren, damit sich eine leitende Bahn formt.

Optional wird durch die Erfindung die hohe Auflösung des Druckverfahrens in der Z-Achse genutzt um elektrochemische Nanostrukturen zu erzeugen.

Vorzugsweise wird dabei das erfindungsgemäße Verfahren zur Herstellung einer bzw. gedruckten Redox-Cycling-Zelle auf eine "cross-bar"-Architektur übertragen und zu dieser erweitert, so dass nicht nur 1x1 Leiterbahn und Zelle, sondern z. B. auch 2x2 oder z. B. 4x4, Leiterbahnen und eine entsprechende Anzahl an Redox-Cycling Zellen nebeneinander angeordnet werden.

In diesen Konfigurationen dienen an den Kreuzungspunkten die Oberflächenbereiche der ersten Leiterbahnen als untere Elektroden für mehrere Redox-Cycling-Zellen gleichzeitig. Ferner dienen an den Kreuzungspunkten die Oberflächenbereiche der zweiten Leiterbahnen als obere Elektroden für das notwendige Redox-Cycling-Verfahren.

Der Aufbau einzelner Redox-Cycling-Zellen bzw. Speicherzellen mittels Druckverfahren z. B. mittels eines Tintenstrahldruckverfahrens kann somit mindestens die nachfolgenden Schritte aufweisen:
a) Auf dem Substrat wird eine erste, elektrisch leitfähige Elektrode angeordnet,
b) auf die erste Elektrode wird eine poröse dielektrische Schicht angeordnet, bei der die Poren bis auf die Oberfläche der ersten Elektrode führen,
c) auf die dielektrische Schicht wird eine zweite, elektrisch leitfähige Elektrode angeordnet,
   wobei mindestens einer der Schritte a) bis c) mit einem Druckverfahren von elektrisch leitfähigen und/oder elektrisch isolierenden Partikeln durchgeführt wird,
d) Passivierung der Schicht-Struktur.

Es versteht sich, dass die Elektroden kontaktierbar ausgestaltet sind, indem sie über die freien Enden der auf diese Weise kontaktbierbaren Leiterbahnen kontaktiert werden.

Somit wird an einem Kreuzungspunkt zumindest auf die erste Elektrode punktförmig eine poröse dielektrische Schicht angeordnet, bei der die Poren des Dielektrikums bis auf die Oberfläche der ersten Elektrode führen. Die Poren in der dielektrischen Schicht sind mit redoxaktiven Molekülen gefüllt. Vorzugsweise sind die redoxaktiven Moleküle bereits in der Tinte enthalten.

Der nanoskalierte Redox-Cycling Speicher ist vorzugsweise nur mittels Drucktechnologien und ohne zusätzliche Ätzschritte oder Opferschichten hergestellt. In diesem Design werden die in der Z-Achse übereinander angeordneten Elektroden, die durch ein nanoskaliertes Dielektrikum getrennt werden, vorzugsweise vollständig gedruckt.

Es gibt bei diesem Verfahren vorteilhaft keine Ätzschritte. Dies wird dadurch erreicht, dass die drei Schichten, 1. erste untere Leiterbahn 2. nanoporöse dielektrische Schicht und 3. zweite obere Leiterbahn vorzugsweise unterschiedliche Porosität aufweisen.

Die Tinte jeder weiteren Schicht sollte eine größere Partikelgröße haben als die vorhergehende, untere Schicht, sodass die Schichten während des Druckens in der flüssigen Phase, z. B. mittels Tintenstrahldruck, nicht in die darunter liegende Schicht hineinfließen können. Dadurch ist es möglich, die verschiedenen Lagen zuverlässig elektrisch zu trennen und Kurzschlüsse durch Brücken aus leitendem Material, das durch die dielektrische Trennschicht fließt, zu verhindern.

Vorteilhaft wird die Tinte für die poröse dielektrische Schicht so vorbereitet, dass sie nach ihrer Deposition auf die erste Leiterbahn, z. B. mittels eines Tintenstrahldrucks, aushärtet und die gewünschte Porosität aufweist, aber zugleich noch immer genug Flüssigkeit enthält um einen Transport der Redox-Moleküle zu den Elektroden zu gewährleisten.

Dieser Effekt kann erfindungsgemäß durch die Verwendung von Sol-Gel-Materialien und einer Sol-Gel-Tinte mit einem Lösungsmittel mit niedrigem Dampfdruck bzw. niedriger Dampfrate bzw. hohem Siedepunkt erreicht werden.

Vorzugsweise weist die Tinte hierfür z. B. Tetramethylorthosilicat (TMOS), Tetraethylorthosilicat (TEOS), Tetraisopropylorthosilicat (TPOS) als Silikat für das Sol-Gel auf. Die Tinte kann auch mit anderen Materialien wie z. B. mit Aluminium-(2-propylat), Aluminium-(2-butylat), Zirconiumpropylat, Titanethylat, Titan-(2-propylat) oder ähnlichem hergestellt werden. Generell soll für eine Sol-Gel-Tinte für das nanoporöse Dielektrikum ein Alkoxid eines Elements verwendet werden ausgewählt aus der Gruppe Silizium, Titan, Aluminium, Zirconium, Germanium, Zinn, Blei und Antimon.

Ein weiterer Aspekt für das Herstellen dieser Tinte betrifft das Mischen der Alkoxidlösung mit einem Alkohol, entionisiertem Wasser und einem Säurekatalysator und/oder Basenkatalysator mit dem redoxaktiven Molekül zur Herstellung der Tinte für das nanoporöse Dielektrikum.

Die Tinte für das nanoporöse Dielektrikum kann aber z. B. auch Hydrogel als dielektrisches nanoporöses Material, bzw. die Bestandteile zur Ausbildung von Hydrogelen umfassen.

Als Lösungsmittel für die nach dem Trocknen des nanoporösen Dielektrikums verbleibende Flüssigkeit können insbesondere aber nicht ausschließlich Glycerin, unterschiedliche Glykole wie z. B. Ethylenglykol, Diethylenglykol, Trithylenglykol, Propylenglykol, Dipropylenglykol, Tripropylenglykol, und so weiter verwendet werden, sowie auch Polyglykole mit unterschiedlichen Kettenlängen z. B. mit bis zu 200, 300, 400, oder mehr Monomereinheiten. Es ist also denkbar, Polyethylenglykol, Polypropylenglykol und so weiter zu verwenden.

Zusätzlich kann die Tinte, wie erwähnt, optional und abhängig von der Speicherart und Anordnung bereits ein redoxaktives Molekül beinhalten.

Als redoxaktive Moleküle kommen z. B. Hexacyanoferrat, Iridiumhexachlorid, Ferrocen und deren Derivative wie z. B. Ferrocenmethanol, Ferrocendimethanol, Ferrocenecarbonsäure, Ferrocendicarbonsäure, Quinone und deren Derivative wie z. B. Orthoquinone, Dopamine, Benzoquinone und so weiter in Frage, wie auch andere redoxaktive Moleküle.

Nach der Deposition der zweiten Leiterbahn als obere Elektrode über dem Dielektrikum, sollen die Redox-Moleküle in der verbleibenden Flüssigkeit der dielektrischen nanoporösen Schicht frei diffundieren und an die Elektroden für die Redoxreaktion gelangen.

Die dielektrische nanoporöse Schicht erfüllt mindestens zwei Funktionen:
1.) Sie entkoppelt die beiden Elektroden, das heißt die untere und die obere, mit einer sehr dünnen, in der Regel kleiner als 1000 nm, am besten 100 - 300 nm dicken, dielektrischen Schicht elektrisch voneinander.
2.) Das Dielektrikum erlaubt im fertig ausgebildeten Zustand die Diffusion der elektrochemisch aktiven Moleküle (Redox-Moleküle) an die Elektroden, damit ein Redox-Cycling-Prozess zwischen der unteren und der oberen Elektrode stattfinden kann.

Alle Materialien, die diese zwei Anforderungen erfüllen, können für die nanoporöse dielektrische Schicht verwendet werden, insbesondere sogenannte Sol-Gel-Materialien oder Hydrogele, aber auch andere Materialien. Die Sol-Gel-Bildung eines Silica-Gels am punktförmig aufgetragenen Dielektrikum folgt dabei den Schritten, wie in der Veröffentlichung "The Sol-Gel Preparation of Silica Gels" beschrieben wurde (Buckley, AM, Greenblatt, M. 1994. Journal of Chemical Education. Volume 71, No. 7, 599-602) und deren Inhalt insbesondere zur Herstellung des Sol-Gels hiermit in diese Patentanmeldung unter Bezugnahme inkorporiert wird.

In einem weiteren Schritt wird die aus einer Vielzahl an Speicherzellen bestehende Speicherstruktur mit einem nicht porösen Dielektrikum beschichtet, also vollständig passiviert. Hierzu kann z. B. ein Laminierungsverfahren durchgeführt werden. Nur die Kontaktstellen der Leiterbahnen für die elektrische Kontaktierung und dem Anlegen von Spannung bleiben frei.

Eine Passivierungsschicht mit einer nicht-porösen, und/oder nicht dampf- und/oder gasdurchlässigen Schicht bewirkt vorteilhaft, dass die Flüssigkeit, falls vorhanden, in der dielektrischen nanoporösen Schicht nicht verdampft. Zusätzlich sorgt die Passivierungsschicht als Schutzschicht für eine größere mechanische Stabilität der Strukturen.

Es ist vorteilhaft möglich, das Zellen-Array auch in der Höhe zu erweitern, um die Anzahl der Zellen pro Fläche und damit die Speicherdichte zu vergrößern. In einem solchem Design wird ein weiteres Dielektrikum auf der oberen Elektrode aufgebracht und darauf folgend im nächsten Schritt eine zweite obere Elektrode.

Diese Konfiguration kann weiter in die Z-Richtung erweitert werden, und wird nur durch die Problematik der Kontaktierung von Leiterbahnen für die Speichersteuerung begrenzt. Die Leiterbahnen können des Weiteren auch in Z-Richtung verknüpft werden.

In einer zweistöckigen Redox-cycling Architektur wird dann die "erste obere Elektrode" als untere Elektrode für die obere Zelle benutzt, während die "zweite obere Elektrode" als obere Elektrode für diese Zelle wirkt.

Während des Redox-Cycling können die elektrochemisch aktiven Moleküle, die Redox-Moleküle, fortwährend im Flüssigkeitsvolumen der dielektrischen nanoporösen Zwischenschicht des Dielektrikums an den Elektroden abwechselnd oxidiert und reduziert werden. Diese Reaktionen finden also zwischen den Elektroden statt. Dafür werden auf den Elektroden entsprechende oxidierende und reduzierende Potentiale angelegt, sodass die Redox-Moleküle bei Berührung der Elektroden direkt oxidiert bzw. reduziert werden. Dadurch, dass jedes Molekül abwechselnd an der einen Elektrode oxidiert und dann an der anderen Elektrode wieder reduziert werden kann trägt jedes Molekül mehrfach zum Ladungstransport zwischen den Elektroden bei, was wiederum zu einer Verstärkung des Gesamtstroms führt.

Für bestimmte Anwendungen (z. B. für WORM - write once read many memory) können auch irreversible Oxidationszustände angestrebt werden. In diesem Fall ist die Rückreaktion nicht möglich. Beispielweise weisen die Moleküle aus der Viologen-Familie vorteilhaft solche Eigenschaften auf. Sie kommen meistens in drei Oxidationszuständen vor, in denen die zweite Oxidationsreaktion meistens irreversibel verläuft:

V²⁺ ↔ V⁺ → V⁰

Alle Moleküle, die dieser Reaktion folgen, können grundsätzlich für WORM-Speicherzellen verwendet werden.

Die Bewegung der Redox-Moleküle im flüssigen Medium des Dielektrikums zwischen den Elektroden ist durch die Diffusion im nanoporösen Dielektrikum getrieben. Bei einer diffusionsgetriebenen Bewegung skaliert die Transportzeit mit dem Quadrat der Strecke, daher ist für die Realisierung eines solchen Speichers eine spezielle Anordnung der Elektroden nötig, in der die Elektroden sehr nah aneinander liegen. Die Effizienz des Redox-Cyclings bzw. die Verstärkung des Signals ist vom Quadrat des Abstandes zwischen den Elektroden abhängig.

Für die Elektroden wird idealerweise ein Abstand im Nanometer bis Mikrometer-Bereich verwendet, was eine große Stromverstärkung erlaubt. Der absolute Redox-Cycling-Strom skaliert dabei linear mit der Konzentration der Redox-Moleküle.

Auf diese Weise wird insbesondere eine gedruckte, auf Redox-cycling basierende, elektrochemische Speichervorrichtung, die als nicht-volatiler Speicher wirkt, bereitgestellt. Besondere Eigenschaften, die diese Vorrichtung aufweist sind:
- nicht-volatiler Speicher;
- niedrige Produktionskosten (<1 Cent) durch Druckverfahren (Rolle zu Rolle);
- energiesparende (fJ-nJ je Vorgang) Auslese- und Schreibvorgänge;
- Verschiedene Konfigurationen in Abhängigkeit vom verwendeten redoxaktiven Molekül: "read-only memory" (ROM), "write once read many memory" (WORM) und "re-writable memory" (RW),
- Typische absolute Speicherkapazitäten von wenigen Bit bis zu mehreren KBytes;
- Sehr große Varianz in der Realisierung der Speicherdichte möglich in Abhängigkeit von der Herstellungstechnik und des Ausleseverfahrens;
- Möglichkeit von Multi-Level-Kodierung, das heißt Speicherzellen, bei denen nicht nur zwei Zustände "0" und "1" aufgeschrieben werden können, sondern mehr, wie z. B. "0", "1", "2" und "3" und so weiter. Diese können durch das Herstellungs- und/oder Ausleseverfahren erreicht werden. Unter Schreiben versteht man erfindungsgemäß die Aktivierung/Deaktivierung des Moleküls um es entsprechend redoxaktiv/redoxinaktiv zu machen. Beispielweise kann man dies durch die Ände rung des Oxidationszustands des Moleküls wie beim Viologen (V²⁺ ↔ V⁺ → V⁰) erreichen.

Es können aber auch strukturelle Änderungen des Moleküls, die durch die Oxidation/Reduktion verursacht werden, wie z. B. bei unterschiedlichen Ferrocen-Derivativen (A ↔ B ↔ C) erreicht werden. Um alle diese möglichen Änderungen zusammenzufassen und um Ladungsbilanz-Probleme in den Formeln zu vermeiden, werden die Moleküle schematisch als A ↔ B, B ↔ C, A ↔ D, und so weiter bezeichnet.
- Typische erreichbare Speicherdichten des Sensors (ohne Zuleitung): 10 - 10⁵ pro Bit/mm² in Abhängigkeit vom Herstellungsverfahren. Bei multi-level-Speicherzellen ist die Speicherdichte deutlich höher.
- Kompatibilität mit Vorrichtungen und Protokollen für RFID/NFC und anderen drahtlosen Kommunikationssystemen, die im Internet-of-Things (IoT) benutzt werden;
- Kompatibilität mit Vorrichtungen und Prozessen der gedruckter Elektronik für Anwendungen in IoT;
- mögliche Nutzung nicht-toxischer/umweltbelastender Materialien für die Speicherherstellung (insbesondere für den Einsatz in Lebensmittelverpackungen);
- Redox-cycling Verfahren ohne Referenzelektrode, da abgeschlossenes Speichersystem.

Das Verfahren zur Herstellung der Speicherzelle(n) ist insbesondere gekennzeichnet dadurch, dass die erste Leiterbahn und/oder das Dielektrikum und/oder die zweite Leiterbahn mit einem Druck-Verfahren und zwar insbesondere mir Tintenstrahldruck bereitgestellt werden kann. Dies ist vorteilhaft preiswerter als Siliziumfabrikationstechnologien.

Das Verfahren kann ausgeführt werden durch die Wahl einer Tinte für das Dielektrikum, welche nach dem Aufbringen auf die erste Leiterbahn getrocknet wird und ein Sol-Gel oder ein Hydrogel mit Poren ausbildet. Dies stellt insbesondere nach einem Printvorgang eine vergleichsweise einfache Möglichkeit dar, das nanoporöse Dielektrikum zu definieren und mit einer bestimmten Größe an Poren bereit zu stellen. Hierzu kann ein Verfahren genutzt werden wie es z. B. in The Sol-Gel Preparation of Silica Gels beschrieben wurde (Buckley, AM, Greenblatt, M. 1994. Jouranl of chemical education. Volume 71, No. 7, 599-602). Diese Veröffentlichung und das Verfahren zur Herstellung der Sol-Gele werden durch Verweis vollständig in die vorliegende Patentanmeldung übernommen.

Erfindungsgemäß kann eine Tinte gewählt werden, welche bereits neben den Bestandteilen zur Ausbildung der Gele auch die redoxaktiven Moleküle umfasst, die nach dem Druck bzw. der Ausbildung des nanoporösen Dielektrikums in den Poren des Dielektrikums an die Elektroden diffundieren und an diesen elektrochemisch reagieren. Dies stellt vorteilhaft eine deutliche Vereinfachung des Verfahrens dar.

Es versteht sich, dass die Verfahrensschritte nach Patentanspruch 1 wiederholt werden können. Dadurch wird vorteilhaft bewirkt, dass die Schritte zur Ausbildung einer Vielzahl an orthogonal zueinander angeordneten Leiterbahnen in einem Speicherarray herangezogen werden können. Dadurch wird vorteilhaft bewirkt, dass eine "crossbar"-Struktur bereitgestellt wird.

Mittels der "crossbar"-Architektur von mehreren Redox-Cycling-Speicherzellen an den Kreuzungspunkten wird vorteilhaft bewirkt, dass man pro 2n Kontaktpunkten n^2 Redox-Cycling Zellen und entsprechend n^2 Bits erzeugt. Dies führt zur höchstmöglichen zweidimensionalen Packungsdichte.

Es ist wichtig zu verstehen, dass auch ohne Redox-Cycling-Reaktion in dieser Speicherart elektrochemische Ströme zu Stande kommen können. Wenn an zwei orthogonal liegenden Leiterbahnen entsprechende Auslesepotentiale (kathodisches Auslesepotential_{red} und anodisches Auslesepotential_{Ox}) angelegt werden um den Zustand des Bits auszulesen, wird an allen Kreuzungspunkten mit redoxaktiven Molekülen auf den Leiterbahnen ein elektrochemischer Strom erzeugt. Da aber an allen Bits bis auf den Kreuzungspunkt der Leiterbahnen nur eine Elektrode auf eines der beiden Auslesepotentiale (Ox oder Red) gelegt wird, ist in den anderen Bits nur eine Teilreaktion, also A → B, oder B → A möglich. Der Strom wird also nicht verstärkt und weist damit einen deutlich niedrigeren Wert auf als für den Bit am Kreuzungspunkt beider adressierten Leiterbahnen, wo die Hin- und die Rückreaktion möglich ist.

Der zu überschreitende Schwellwert, an dem ein gemessener Strom durch Redoxcycling-Verstärkung der Reaktion A <-> B und damit als Zustand 1 gewertet wird, ist erfindungsgemäß vorzugsweise mindestens dreimal so hoch, wie das nicht verstärkte Rauschen (current noise). Diese Definition gilt für alle genannten Speicherzellen ROM/WORM/RW.

Durch diese größeren Stromstärkeunterschiede am Kreuzungspunkt zu allen anderen Speicherzellen des Arrays ergibt sich ein hohes Signal-zu-Rauschen-Verhältnis. Dieses Signal-zu-Rauschen-Verhältnis ermöglicht den Redox-Cycling basierten elektrochemischen Speicher. Der Zustand eines Bits als "1" wird dann mit einem gewissen Mindeststrom verknüpft, der bei Anlegen der Auslesepotentiale erreicht werden muss. Dieser Mindeststrom muss selbstverständlich größer definiert sein, als der Hintergrundstrom durch die Halbreaktion auf den nicht angesprochenen Bits auf den jeweiligen Leiterbahnen.

Mit dem Verfahren können ferner durch die Wahl von Tinte mit unterschiedlichen Konzentrationen und/oder Substanzen an redoxaktiven Molekülen für das Speicherarray folgende Vorteile im Verfahren genutzt werden:
So ist es möglich, eine Speichzelle mit Multi-Level-Kodierung zu realisieren, in der außer zwei binäre Zustände "0" (keine Redox-Moleküle) und "1" (anwesende Redox-Moleküle) auch weitere Zustände vorhanden sind. Dieses wird z. B. durch die Deponierung von Tinten mit unterschiedlichen Konzentrationen an Redox-Moleküle in den Speicherzellen realisiert.

Beispiel: Bei dem Ausleseverfahren werden 16 unterschiedliche Konzentrationen, z. B. 0 µM, 1 µM, 5 µM, 10 µM, 25 µM, 50 µM, 100 µM, 200 µM, 300 µM, 400 µM, 500 µM, 600 µM, 700 µM, 800 µM, 900 µM, 1000 µM vom redoxaktiven Molekül Ferrocendimethanol unterschieden. Dadurch können vorteilhaft 16 unterschiedliche Zustände in jede einzelne Speicherzelle geschrieben werden. Es können dann für den Speicher statt einer binären Basis z. B. ein Hexadezimalsystem genutzt und Einheiten des hexadezimalen Systems, 16-Basis (HEX), geschrieben werden: 0, 1, 2, 3, 4, 5, 6, 7, 8, 9, A, B, C, D, E, F, kurz 0 bis F.

Dadurch wird die Speicherdichte, das heißt die mögliche Art Speicherzustände je physikalische Fläche vorteilhaft erhöht. Damit bieten diese Speicherzellen mit Multi-Level-Kodierung viel höhere Kapazitäten, obwohl die Anzahl der Speicherknoten gleich bleibt. Beispielweise fasst man normalerweise acht Bits zusammen in einem Byte. Bei binären ("0" oder "1") Bits entspricht ein Byte maximal der Zahl Sum(n = von 0 bis 7) 2^n = 2^0 + 2^1 + 2^2 + 2^3 + 2^4 + 2^5 + 2^6 + 2^7 = 255. Das heißt man kann mit einem binärem Byte Zahlen von 0 bis 255 speichern.

Erfindungsgemäß entspricht im Vergleich hierzu durch die Nutzung hexadezimaler Byte ("A" bis "9") die maximal darstellbare Zahl in einem Byte Zahl Sum(n = von 0 bis 7) 16^n = 16^0 + 16^1 + 16^2 + 16^3 + 16^4 + 16^5 + 16^6 + 16^7 = 286.331.153, das heißt man kann die Zahlen von 0 bis 286.331.153 speichern. Das führt erfindungsgemäß zu einer deutlich höheren Speicherdichte als bei herkömmlichen Speichersystemen. Die Unterschiede zwischen dem binären und dem hexadezimalen Speicherzellensystem kann man der Tabelle 1 (binär) und 2 (HEX) entnehmen. Erfindungsgemäß werden beide Speichersysteme und weitere Systeme realisiert. Ein erfindungsgemäßer elektrochemischer Speicher bzw. eine solche Speicherzelle , umfasst zunächst mindestens eine Anordnung aus einer ersten elektrisch kontaktierbaren Leiterbahn auf einem nicht leitenden Substrat, einer orthogonal hierzu angeordneten zweiten elektrisch kontaktierbaren Leiterbahn, wobei die Leiterbahnen am Kreuzungspunkt Elektrodenfunktion aufweisen und wobei am Kreuzungspunkt zwischen den beiden Leiterbahnen ein poröses Dielektrikum mit einem in den Poren befindlichen Flüssigkeitsvolumen umfassend frei in den Poren diffundierbare redoxaktive Moleküle angeordnet ist. Diese redoxaktiven Moleküle werden an den Elektroden der Leiterbahnen durch Anlegen von elektrischer Spannung (Auslesepotentiale Ox und Red) zur Erzeugung eines definierten Zustandes bzw. zum Auslesen des Zustandes oxidiert und reduziert wobei der Speicher aus Substrat, Leiterbahnen und Dielektrikum vollständig durch eine Passivierungsschicht passiviert ist. Es gibt keine gesonderten Zuführungen oder Ableitungen für redoxaktive Moleküle, so dass es sich um einen nicht volatilen Speicher, genauer um eine einzige Speicherzelle hiervon handelt. Schreibvorgänge für WORM- und RW-Speicherzellen sind ebenfalls möglich, wie gezeigt werden wird.

Ein erfindungsgemäßes Speicherarray weist eine Vielzahl solcher passivierter elektrochemischer Speicher(zellen) in "crossbar"-Konfiguration auf, hergestellt mit dem oben beschriebenen Verfahren.

Vorzugsweise ist in einer Ausgestaltung der Erfindung ein Speicherarray durch eine Vielzahl an Speicherzellen gekennzeichnet. Ein erfindungsgemäßes Speicherarray ist insbesondere dadurch gekennzeichnet, dass die Speicher, bzw. die einzelnen Speicherzellen, Dielektrika mit jeweils verschiedenen Konzentrationen an redoxaktiven Molekülen und/oder verschiedene und/oder keine redoxaktive Moleküle aufweisen. Dadurch werden vorteilhaft Speicherzellen mit einer Multi-Level-Kodierung aus der vorgeschlagenen Vorrichtung entwickelt.

Die Konfiguration mit mehreren Arten von Redox-Molekülen kann besonders vorteilhaft zudem mit der Konfiguration von mehreren Konzentrationen der redoxaktiven Moleküle kombiniert werden um weitere, noch komplexere Speicherzellen, mit Multi-Level-Kodierung herzustellen.

Dadurch wird vorteilhaft bewirkt, dass ein nicht-volatiler Speicher durch eine gedruckte Vorrichtung basierend auf Redox-Cycling und "crossbar"-Architektur bereitgestellt wird. Der Speicher wird hierzu mit dielektrischer nanoporöser Tinte, welche Redox-Moleküle umfasst, hergestellt.

Das Speicherarray kann mindestens einen Speicherzustand ohne ein redoxaktives Molekül zur Ausbildung von Zustand 0 und mindestens einem Speicherzustand mit einem redoxaktiven Molekül umfassen, wobei das redoxaktive Molekül durch Anlegen von Spannung (Auslesepotential Ox und Red) über die Leiterbahnen an die Elektroden reversibel nur eine oxidierte und eine reduzierte Form zur Ausbildung von Zustand 1 ausbildet.

In den nachfolgenden Tabellen 3 bis 5 stellt das Symbol Fragezeichen ("?") einen unbekannten Speicherzellenwert dar. GND=Masse; Auslesepotential = Potential an der Kathode und an der Anode, das nur zum Treiben der reversiblen Redoxreaktion A ↔ B zum Auslesen des Speicherzellenwerts bzw. Zustands "1" ausreicht, nicht jedoch um Schreibvorgänge zu erzeugen; Schreibpotential = Potential an der Kathode und an der Anode, das zum Treiben einer reversiblen oder irreversiblen Redoxreaktion zur Umschreibung der redoxaktiven Moleküle A und/oder B durch Oxidation und/oder Reduktion und Erzeugung des Speicherzellenwerts bzw. Zustands "0" (binär) oder eines Zwischenwerts (hex oder anderes System) ausreicht. Im Falle von WORM erzeugt ein Schreibpotential gerichtet einen Zustand von fortlaufend geringerer Konzentrationen an [A und B] in der Speicherzelle, im Falle von RW ist die Konzentration an [A und B] erneuerbar.

### ROM

1.a. ROM: Eine ROM-Speicherzelle ist vorteilhaft dadurch gekennzeichnet, dass sie ein nanoporöses Dielektrikum entweder ohne oder mit einem redoxaktiven Molekül umfasst. In der ROM mit einem redoxaktiven Molekül findet genau eine Redoxreaktion statt, mit der das redoxaktive Molekül reversibel zwischen seinen zwei Oxidationsstufen wechselt, dem oxidierten und dem reduzierten Zustand.

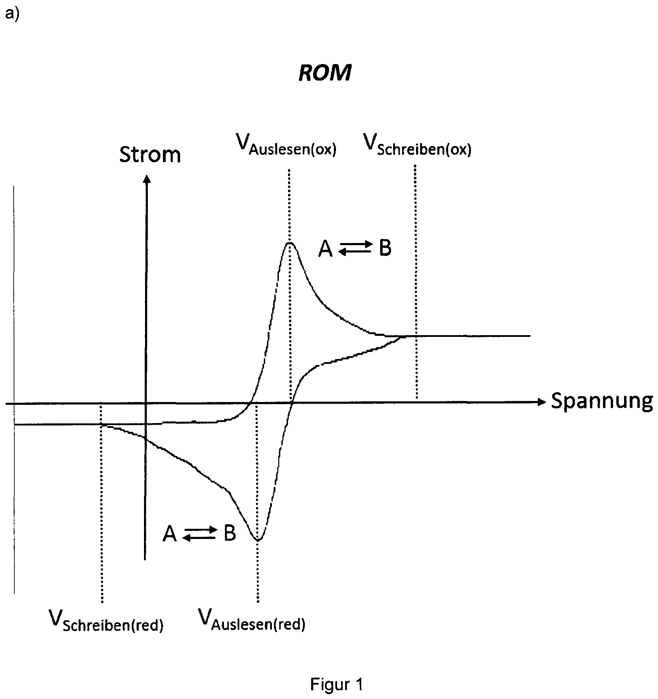

Folgende Modi zum Beschreiben und Auslesen sind möglich, siehe Tabelle 3a, 3b und die Figur 1a mit entsprechendem zyklischen Voltammogram.

**Tabelle 3 a: ROM - Binäres System**

| | | | | | | | |
|---|---|---|---|---|---|---|---|
| Wert (binär) | | | 0 | | | 1 | |
| Stromwert (diskret) | | | 1 | | | 2 | |
| Konzentration [A+B] (diskret) | | | 0 | | | 1 | |
| | | | | | | | |

| Modus | Redox-Molekül Konzentration (diskret) | Potential Kathode | | Potential Anode | Stromwert (diskret) | | Speicherzellenwert |
|---|---|---|---|---|---|---|---|
| Stillstand | [A+B] = 0 | keine | | keine | keine | | ? |
| Auslesen | [A+B] = 0 | V_{Auslesen(red)} | | V_{Auslesen(ox)} | 1 | | "0" |
| Stillstand | [A+B] ≠ 0 | keine | | keine | keine | | ? |
| Auslesen | [A+B] ≠ 0 | V_{Auslesen(red)} | | V_{Auslesen(ox)} | 2 | | "1" |
| Schreiben | nicht möglich | | | | | | |

Für eine binäre ROM-Konfiguration werden also zwei verschiedene Arten der dielektrischen nanoporösen Schicht an den Kreuzungspunkten aufgebracht: eine mit redoxaktiven Molekülen (so genannter Zustand "1") und eine ohne redoxaktive Moleküle (Zustand "0"). Wenn an der unteren und an der oberen Elektrode über die Leiterbahnen als Auslesepotentiale, die das Normalpotential des redoxaktiven Moleküls übersteigende Oxidations- und Reduktionspotentiale angelegt werden, wird in den Zellen mit redoxaktiven Molekülen ein Redox-Cycling stattfinden, während in der Zelle ohne redoxaktive Moleküle nur Hintergrundrauschen auftritt. Durch das Auslesen des Stromsignals der Elektroden kann man entsprechend "1"- und "0"-Zustände der Speicherzelle erkennen. Das redoxaktive Molekül soll entsprechend ein möglichst niedriges reversibles Oxidations- und Reduktionspotential haben, um die Ausleseenergie zu reduzieren. Für ROM findet nur die folgende Reaktion statt:

A ↔ B

1.b. Multi-level ROM: wie 1.a. aber mit mehreren Konzentrationen von Redox-Molekülen, z. B. mit 16 verschiedenen Konzentrationen von z. B. 0 µM, 1 µM, 5 µM, 10 µM, 25 µM, 50 µM, 100 µM, 200 µM, 300 µM, 400 µM, 500 µM, 600 µM, 700 µM, 800 µM, 900 µM, 1000 µM an z. B. Ferrocendimethanol als redoxaktives Molekül für die Erzeugung von hexadezimalen Speicherzellen im Speicherarray.

Dann ergeben sich folgende Modi zum Auslesen des ROM-Speicherarray gemäß der Tabelle 3b.

**Tabelle 3 b: ROM - Hexadezimales System (HEX). Dieser Teil ist auch nach den Schreibvorgängen in WORM-Speicherarray und RW-Speicherarray gültig.**

| | | | | | | | | | | | | | | | | |
|---|---|---|---|---|---|---|---|---|---|---|---|---|---|---|---|---|
| Wert (HEX) | 0 | 1 | 2 | 3 | 4 | 5 | 6 | 7 | 8 | 9 | A | B | C | D | E | F |
| Stromwert (diskret) | 1 | 2 | 3 | 4 | 5 | 6 | 7 | 8 | 9 | 10 | 11 | 12 | 13 | 14 | 15 | 16 |
| Konzentration [A+B] (diskret) | 0 | 1 | 2 | 3 | 4 | 5 | 6 | 7 | 8 | 9 | 10 | 11 | 12 | 13 | 14 | 15 |

Multi-level ROM (HEX) - beispielhaft, das heißt nicht alle 16 Zustände werden beschrieben:

| Modus | Redox-Molekül Konzentration (diskret) | Potential Kathode | Potential Anode | Stromwert (diskret) | Speicherzellenwert |
|---|---|---|---|---|---|
| Stillstand | [A+B] = 0 | keine | keine | keine | ? |
| Auslesen | [A+B] = 0 | V_{Auslesen(red)} | V_{Auslesen(ox)} | 1 | "0" |
| Stillstand | [A+B] = 3 | keine | keine | keine | ? |
| Auslesen | [A+B] = 3 | V_{Auslesen(red)} | V_{Auslesen(ox)} | 4 | "3" |
| Stillstand | [A+B] = 10 | keine | keine | keine | ? |
| Auslesen | [A+B] = 10 | V_{Auslesen(red)} | V_{Auslesen(ox)} | 11 | "A" |
| Stillstand | [A+B] = 15 | keine | keine | keine | ? |
| Auslesen | [A+B] = 15 | V_{Auslesen(red)} | V_{Auslesen(ox)} | 16 | "F" |
| Schreiben | nicht möglich | | | | |

Es werden entsprechend Auslesepotentiale an der Kathode V_{Auslesen(red)} und/oder an der Anode V_{Auslesen(ox)} angelegt, die oberhalb (Oxidation) bzw. unterhalb (Reduktion) des Normalpotentials des redoxaktiven Moleküls liegen und somit die zyklische Redoxreaktion A ↔ B im Dielektrikum treiben.

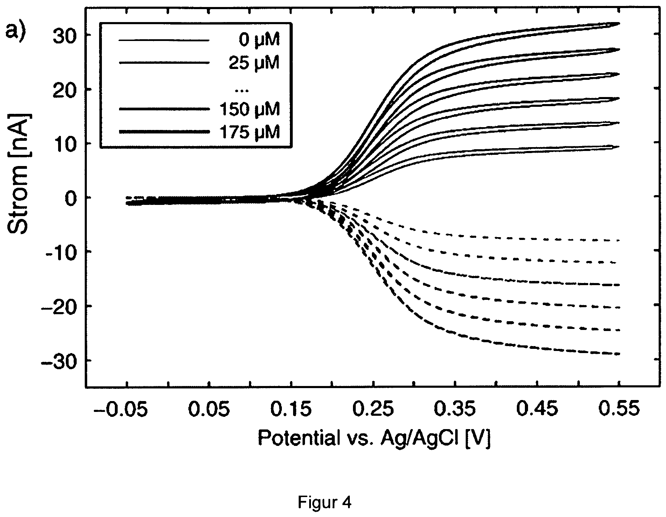

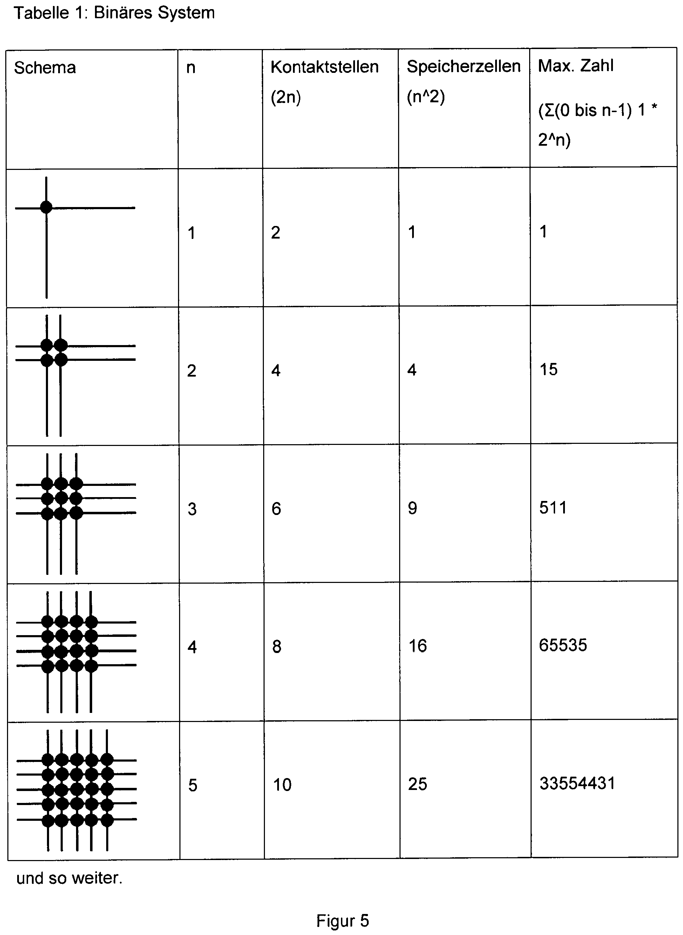

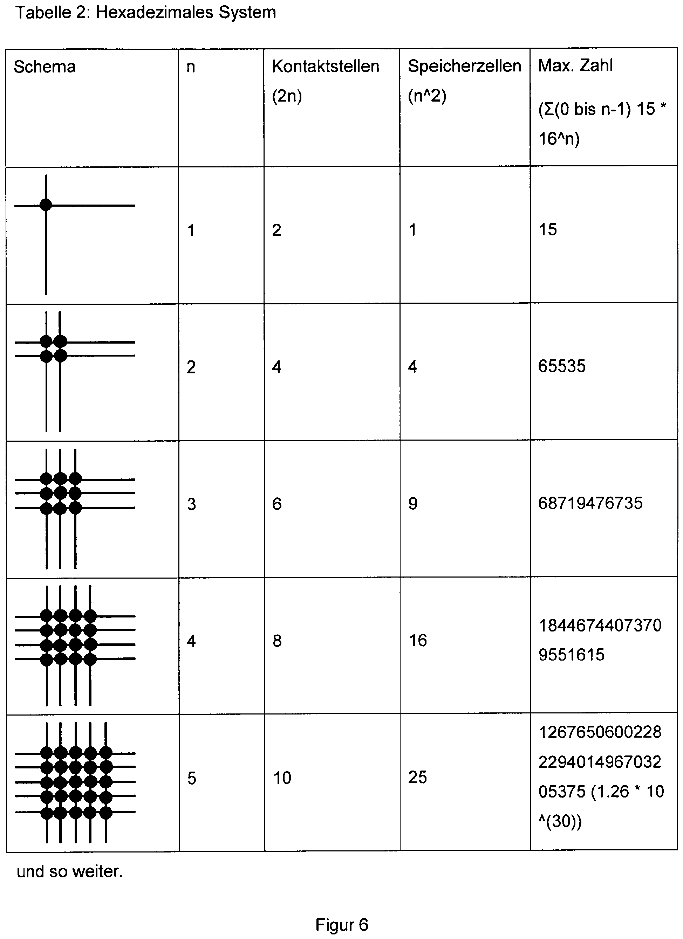

Der Absolutwert des gemessenen Stroms ist linear von der Konzentration des redoxaktiven Moleküls abhängig und kann verschiedenen Speicherzellenwerten zugeordnet werden (siehe auch Figur 4).

### WORM

2.a. WORM: Die WORM-Speicherzelle ist vorteilhaft dadurch gekennzeichnet, dass sie ein nanoporöses Dielektrikum mit einem redoxaktiven Molekül umfasst.

Für die Herstellung einer WORM-Speicherzelle wird das Dielektrikum mit einem redoxaktiven Molekül hoher Konzentration hergestellt. Die Konzentration des redoxaktiven Moleküls wird besonders hoch gewählt um möglichst viele irreversible Schreibvorgänge zu ermöglichen.

In jeder WORM-Speicherzelle findet eine reversible Redoxreaktion statt, und mindestens eine irreversible Oxidation und/oder Reduktion.

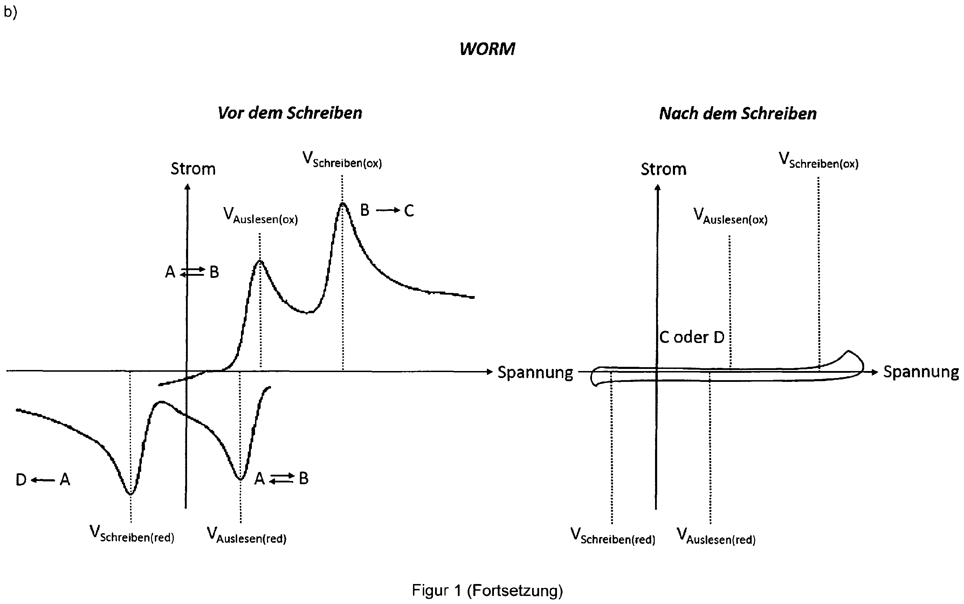

Folgende Modi zum Beschreiben und Auslesen sind möglich, siehe Tabelle 4a, 4b und die Figur 1b mit entsprechendem zyklischen Voltammogram.

**Tabelle 4a: WORM (binär): Auslesen 1 - vor dem Schreiben; Auslesen 2 - nach dem Schreiben; Schreiben - Anlegen von einem Schreibpotential; Default - alle Zellen sind "1"**

| Modus | Redox-Molekül Konzentration (diskret) | Potential Kathode | Potential Anode | Stromwert (diskret) | Speicherzellenwert |
|---|---|---|---|---|---|
| Stillstand | [A+B] ≠ 0 | keine | keine | keine | ? |
| Auslesen 1 | [A+B] ≠ 0 | V_{Auslesen(red)} | V_{Auslesen(ox)} | 2 | "1" |

| Irreversibles Schreiben durch Reduktion | | | | | |
|---|---|---|---|---|---|
| Schreiben | [A+B] ≠ 0 | V_{Schreiben(red)} | GND | - | - |
| Auslesen 2 | [A+B] = 0 | V_{Auslesen(red)} | V_{Auslesen(ox)} | 1 | "0" |

| oder irreversibles Schreiben durch Oxidation | | | | | |
|---|---|---|---|---|---|
| Schreiben | [A+B] ≠ 0 | GND | V_{Schreiben(ox)} | - | - |
| Auslesen 2 | [A+B] = 0 | V_{Auslesen(red)} | V_{Auslesen(ox)} | 1 | "0" |

Es ist durch die Wahl eines geeigneten redoxaktiven Moleküls in der Tinte möglich, mit dem erfindungsgemäßen Verfahren auch WORM-Speicher bereit zu stellen. Hierzu weist die Speicherzelle mindestens zwei Speicherzustände auf, mit jeweils dem selben Molekül, wobei das Molekül ohne Anlegen von Spannung einen ersten Zustand 0 (nicht redoxaktiv) oder 1 (redoxaktiv) ausbildet und durch Anlegen von Spannung irreversibel entsprechend den zweiten Zustand 1 (redoxaktiv) oder 0 (nicht redoxaktiv) ausbildet. Der redoxaktive Zustand "1" weist auf die reversible RedoxReaktion hin, die durch eine erfindungsgemäße Vorrichtung in Redox-Cycling-Strom resultiert.

Für die WORM-Konfiguration wird an allen Kreuzungspunkten eine dielektrische nanoporöse Schicht mit einem löslichen redoxaktiven Molekül (Zustand "1") mit einer entsprechend großen Diffusionskonstante auf der ersten Leiterbahn angeordnet und mit der zweiten oberen Leiterbahn geschlossen, um die Redox-Cycling Speicherzelle zu formen. Das heißt direkt nach der Herstellung haben alle diese Zellen einen Default Wert "1".

Um aus dem Wert "1" einen Wert "0" zu erzeugen, soll ein Potential zwischen den beiden Elektroden des Kreuzungspunktes angelegt werden, welches die Redox-Moleküle irreversibel verändert, so dass bei dem Anlegen von einem "normalen" niedrigen Auslesepotential, keine Redox-Cycling-Reaktion an diesem Kreuzungspunkt mehr stattfindet. Die Redox-Cycling-Reaktion findet nicht mehr statt, weil die irreversibel veränderten Moleküle nicht mehr redoxaktiv sind. Siehe auch die Figur 1b mit entsprechenden zyklischen Voltammogramen für WORM-Speicherzellen.

Diese Redox-Moleküle müssen entsprechend einen niedrigen reversiblen Oxidations- und Reduktionzustand haben, und zusätzlich auch einen höheren irreversiblen Oxidations- oder Reduktionszustand.

Beispielweise weisen die Moleküle aus der Viologen-Familie solche Eigenschaften auf. Diese Moleküle weisen bis zu drei Oxidationszustände auf, in denen die zweite Oxidationsreaktion meistens irreversibel verläuft.

Generell müssen in WORM-Speicherzellen also folgende spannungsgetriebene Reaktionen stattfinden können:
1.)

   A ↔ B

   und
2.)

   B → C

   und/oder
3.)

   A → D

Wobei der Schritt 1) reversibel und die Schritte 2) und/oder 3) irreversibel sind.

Alternativ kann für eine WORM-Konfiguration an allen Kreuzungspunkten eine dielektrische nanoporöse Schicht mit einem unlöslichen Redox-Molekül bzw. einem redoxaktiven Molekül mit einer entsprechend kleinen Diffusionskonstante im so genannten Default Zustand "0" angeordnet werden.

Das heißt, diese Speicherzellen weisen direkt nach ihrer Herstellung einen Wert "0" auf. Um aus dem Wert "0" einen Wert "1" zu erzeugen, soll ein Potential zwischen den beiden Elektroden des Kreuzungspunktes angelegt werden, das die Redox-Moleküle irreversibel verändert, so dass sie löslich werden und eine große Diffusionskonstante bekommen. Dann wird beim Anlegen von einem "normalen" niedrigen Auslesepotential eine Redox-Cycling-Reaktion gemäß Schritt 3.) an diesem Kreuzungspunkt stattfinden.
1.)

   C → B

   und/oder
2.)

   D → A

   und
3.)

   A ↔ B

Das redoxaktive Molekül muss entsprechend irreversibel oxidierbar oder reduzierbar sein. In dem ersten Oxidationszustand sind die redoxaktiven Moleküle nicht löslich und können nicht zwischen den Elektroden diffundieren. Nach der irreversiblen Oxidation werden die Moleküle löslich bzw. mobil und können zwischen den Elektroden frei diffundieren. Sie können dann durch Anlegen von Auslesepotentialen reversibel oxidiert und reduziert werden, siehe Schritt 3).

Die Redox-Moleküle sollen zu der nanoporösen dielektrischen Schicht entsprechend passend ausgewählt werden, weil die Löslichkeit von dem Medium, in dem die Substanz gelöst wird, abhängt. Es können auch restliche Oxidations- bzw. Reduktionsströme in dem Zustand "0" vorkommen, die aus den Molekülen, die sich in der unmittelbaren Nähe der Elektroden befinden, resultieren. Sie sollen dann auch einen reversiblen Oxidations- und Reduktionzustand haben, um ausgelesen zu werden (siehe Figur 1b).

2.b. Multi-level WORM: Der Multi-Level-WORM wird wie für 2.a. bereit gestellt. Beginnend mit einer hohen Konzentration an dem redoxaktiven Molekül im Dielektrikum wird dieses nach und nach durch unterschiedlich hohe Schreibpotentiale zu verschiedenen fortlaufend geringeren Konzentrationen an dem Redox-Molekül umgeschrieben.

Schreibpotentiale werden grundsätzlich über die applizierte Zeit, die Höhe des Schreibpotentials oder des Stroms angelegt um verschiedene Konzentrationen an redoxaktiven Molekülen entstehen zu lassen. Diese Aussage gilt ebenso für RW-Speicherzellen.

Das Maß der Umschreibung ist von diesen Parametern abhängig. Anders als bei binären WORM-Speicherzellen in denen einmal eine Umschreibung erfolgen kann, ist bei der Multi-Level-Kodierung durch Schreibvorgänge eine Vielzahl an Konzentrationen an redoxaktiven Molekülen möglich. Auf diese Weise werden beispielweise insgesamt 16 verschiedene Konzentrationen für die Erzeugung von hexadezimalen Speicherzellen irreversibel umgeschrieben und ausgelesen.

Es ergeben sich auszugsweise folgende Modi für Auslesen und Speichern gemäß der angegebenen Beispiele in der Tabelle 4b (siehe auch Figur 1b und die Tabelle 3b oberer Teil, die ebenso für WORM-Speicherzellen anwendbar ist).

Tabelle 4b: Multi-level WORM (HEX), beispielhaft angegebene für nur zwei Schreibvorgänge, das heißt nicht alle 16 Zustände werden in der Tabelle wieder gegeben: Auslesen 1 - vor dem Schreiben; Auslesen 2 - nach dem Schreiben; Schreiben 1 - Spannungspuls 1 mit bestimmtem Parameter; Schreiben 2 - Spannungspuls 2 mit anderem Parameter; Default - alle Zellen sind "1".

| Modus | Redox-Molekül Konzentration (diskret) | Potential Kathode | Potential Anode | Stromwert (diskret) | Speicherzellenwert |
|---|---|---|---|---|---|
| Stillstand | [A+B] = 15 | Keine | keine | keine | ? |
| Auslesen 1 | [A+B] = 15 | V_{Auslesen(red)} | V_{Auslesen(ox)} | 16 | "F" |

| Schreiben 1 durch Reduktion | | | | | |
|---|---|---|---|---|---|
| Schreiben 1 | [A+B] = 4 | V_{Schreiben(red)} | GND | - | - |
| Auslesen 2 | [A+B] = 4 | V_{Auslesen(red)} | V_{Auslesen(ox)} | 5 | "4" |

| oder Schreiben 1 durch Oxidation | | | | | |
|---|---|---|---|---|---|
| Schreiben 1 | [A+B] = 4 | GND | V_{Schreiben(ox)} | - | - |
| Auslesen 2 | [A+B] = 4 | V_{Auslesen(red)} | V_{Auslesen(ox)} | 5 | "4" |

| Schreiben 2 durch Reduktion | | | | | |
|---|---|---|---|---|---|
| Schreiben 2 | [A+B] = 0 | V_{Schreiben(red)} | GND | - | - |
| Auslesen 2 | [A+B] = 0 | V_{Auslesen(red)} | V_{Auslesen(ox)} | 1 | "0" |

| oder Schreiben 2 durch Oxidation | | | | | |
|---|---|---|---|---|---|
| Schreiben 2 | [A+B] = 0 | GND | V_{Schreiben(ox)} | - | - |
| Auslesen 2 | [A+B] = 0 | V_{Auslesen(red)} | V_{Auslesen(ox)} | 1 | "0" |
| Umschreiben | nicht möglich | | | | |

Es wird also, wie beschrieben, die WORM-Speicherzelle mit einer großen Konzentration an redoxaktivem Molekül hergestellt. Ein erster Schreibvorgang wird durch Anlegen des Schreibpotentials herbeigeführt und schreibt das redoxaktive Molekül irreversibel um bis es eine geringere Konzentration an [A+B] aufweist, hier die diskrete Konzentration 4. Der Schreibvorgang erfolgt entweder durch Oxidation oder Reduktion.

Es lassen sich vorteilhaft alle Zwischenniveaus durch die Form des Schreibpulses einstellen. Beispielweise lässt sich durch die Variierung der Form und Stärke des Spannungspulses aus dem Wert "1" nur ein Teil der Redox-Moleküle irreversibel verändern und dadurch eine bestimmte Konzentration erreichen. Eine Besonderheit in diesem Fall ist, dass man die Speicherzelle immer wieder mit dem richtigen Puls in die Richtung einer niedrigeren Konzentration der Redox-Moleküle (weniger "1", mehr "0") nachschreiben kann, aber nicht in die andere Richtung.

Alternativ hierzu ist der Erstzustand Default "0" für den Fall, dass man zunächst unlösliche Moleküle benutzt. Das heißt durch weitere Spannungspulse kann man mehr und mehr nicht lösliche Moleküle oxidieren und die Konzentration an löslichen redoxaktiven Molekülen erhöhen, die gemäß der Reaktion A ↔ B mehr "1" und weniger "0" Zustände erzeugen.

### RW

Es ist möglich, mit dem erfindungsgemäßen Verfahren ein RW-Speicherarray, also wieder beschreibbare Speicherzellen, bereit zu stellen.

Eine RW-Speicherzelle ist vorteilhaft dadurch gekennzeichnet, dass sie ein nanoporöses Dielektrikum mit einem redoxaktiven Molekül umfasst. In der RW-Speicherzelle finden durch Anlegen von Spannung mindestens zwei reversible Redoxreaktionen statt, mit der das redoxaktive Molekül zwischen mindestens drei Oxidationsstufen wechselt. Nur die Redoxreaktion A <-> B erzeugt den Zustand 1.

Dieses Speicherarray weist mindestens zwei Speicherzustände mit jeweils dem selben Molekül auf, wobei das Molekül ohne Anlegen von Spannung einen ersten Zustand "0" (nicht redoxaktiv) oder "1" (redoxaktiv) ausbildet und durch Anlegen von Spannung reversibel den zweiten Zustand "1' (redoxaktiv) oder "0" (nicht redoxaktiv) wechseln.

3 a. RW-Speicher (binär): Für eine RW-Konfiguration wird an allen Kreuzungspunkten eine dielektrische nanoporöse Schicht mit redoxaktiven Molekülen (Default "1") aufgebracht. Das heißt, direkt nach der Herstellung haben alle Zellen einen Wert "1". Um aus dem Wert "1" einen Wert "0" zu generieren, soll ein Potential zwischen den beiden Elektroden des Kreuzungspunktes angelegt werden, der die Redox-Moleküle reversibel verändert, z. B. durch eine Oxidation bzw. Reduktion in einen zweiten höheren bzw. niedrigeren Oxidationszustand.

Mit einem niedrigen Auslesepotential erfolgt keine Redox-Cycling-Reaktion an diesem Kreuzungspunkt mehr, das heißt die Redox-Cycling-Reaktion findet nicht statt, weil die veränderten Moleküle nicht mehr redoxaktiv sind.

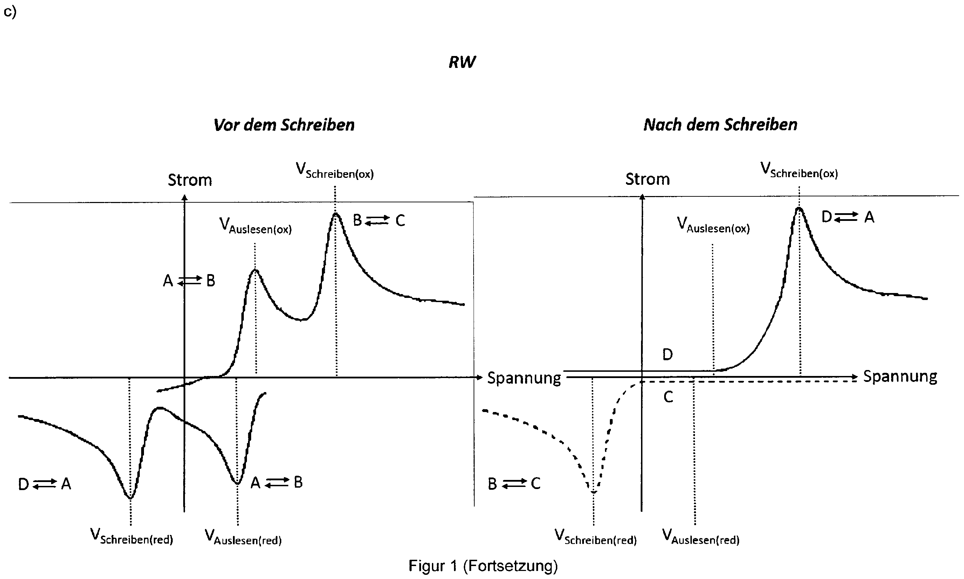

Um wieder aus dem Wert "0" einen Wert "1" zu erzeugen, soll ein umgekehrtes Potential zwischen den beiden Elektroden des Kreuzungspunktes angelegt werden, der die Redox-Moleküle wieder reversibel in den niedrigeren (bzw. höheren) Oxidationszustand zurückversetzt, so dass bei dem Anlegen von einem Auslesepotential des Speicher-Zustands, wieder eine Redox-Cycling-Reaktion gemäß der Redoxreaktion A ↔ B an diesem Kreuzungspunkt stattfindet, siehe Figur 1c mit entsprechenden zyklischen Voltammogramen, und die Tabelle 5a.

**Tabelle 5 a: RW (binär). Auslesen 1 - vor dem Schreiben; Auslesen 2 - nach dem Schreiben; Auslesen 3 - nach dem Umschreiben; Schreiben - Anlegen von einem Schreibpotential; Umschreiben - Anlegen von einem umgekehrten Schreibpotential; alle Zellen mit Default "1"**

| Modus | Redox-Molekül Konzentration (diskret) | Potential Kathode | Potential Anode | Stromwert (diskret) | Speicherzellenwert |
|---|---|---|---|---|---|
| Stillstand | [A+B] ≠ 0 | Keine | keine | keine | ? |
| Auslesen 1 | [A+B] ≠ 0 | V_{Auslesen(red)} | V_{Auslesen(ox)} | 2 | "1" |

| Reversibles Schreiben durch Reduktion | | | | | |
|---|---|---|---|---|---|
| Schreiben | [A+B] ≠ 0 | V_{Schreiben(red)} | GND | - | - |
| Auslesen 2 | [A+B] = 0 | V_{Auslesen(red)} | V_{Auslesen(ox)} | 1 | "0" |

| oder reversibles Schreiben durch Oxidation | | | | | |
|---|---|---|---|---|---|
| Schreiben | [A+B] ≠ 0 | GND | V_{Schreiben(ox)} | - | - |
| Auslesen 2 | [A+B] = 0 | V_{Auslesen(red)} | V_{Auslesen(ox)} | 1 | "0" |

| Umschreiben durch Wiederoxidation (nach Reduktion) | | | | | |
|---|---|---|---|---|---|
| Umschreiben | [A+B] ≠ 0 | GND | V_{Schreiben(ox)} | - | - |
| Auslesen 3 | [A+B] # 0 | V_{Auslesen(red)} | V_{Auslesen(ox)} | 2 | "1" |

| Umschreiben durch Wiederreduktion (nach Oxidation) | | | | | |
|---|---|---|---|---|---|
| Umschreiben | [A+B] ≠ 0 | V_{Schreiben(red)} | GND | - | - |
| Auslesen 3 | [A+B] ≠ 0 | V_{Auslesen(red)} | V_{Auslesen(ox)} | 2 | "1" |

Das redoxaktive Molekül muss entsprechend einen niedrigen reversiblen Oxidations- und Reduktionszustand haben, und zusätzlich auch einen höheren bzw. niedrigeren zweiten reversiblen Oxidations- oder Reduktionszustand.

Derartige Moleküle sind z. B. aromatische Azo-Verbindungen wie Azobenzen, Azotoluen, und so weiter, die in einer Lösung von Dimethylformamid mit Tetra-n-butylammonium perchlorate (TBAP) gelöst sind und erfindungsgemäße RW-Speicherzellen bilden können.

Generell müssen für RW-Speicherzellen folgende Reaktionen stattfinden:
1.)

   A ↔ B

   und
2.)

   B ↔ C

   und/oder
3.)

   A ↔ D

Alternativ wird für eine RW-Konfiguration an allen Kreuzungspunkten eine dielektrische nanoporöse Schicht mit unlöslichen Redox-Molekülen bei der Herstellung im Dielektrikum vorgelegt, welche entsprechend eine kleine Diffusionskonstante aufweisen. Diese Speicherzellen haben also direkt nach ihrer Herstellung einen Default "0". Um aus dem Wert "0" einen Wert "1" zu erzeugen, soll ein Potential zwischen den beiden Elektroden des Kreuzungspunktes angelegt werden, das die Redox-Moleküle reversibel verändert, so dass sie löslich werden und eine große Diffusionskonstante bekommen.
1.)

   C ↔ B

   und/oder
2.)

   D ↔ A

   und
3.)

   A ↔ B

Dann wird beim Anlegen von einem "regulär" niedrigen Auslesepotential eine Redox-Cycling-Reaktion an diesem Kreuzungspunkt gemäß Schritt 3) stattfinden und Zustand "1" erzeugen. Im Zustand "0" ist dann die Diffusion der Moleküle so weit eingeschränkt, dass nur eine Halbreaktion der Moleküle in direkter Nähe zur Elektrodenoberfläche, aber kein redox cycling verstärkter Strom stattfinden kann. Damit diese Ströme nicht als "1" erkannt werden, wird ein Signal nur als "1" gelesen, wenn es einen Schwellwert überschreitet.

Um aus dem Wert "1" wieder einen Wert "0" zu erzeugen soll ein umgekehrtes Potential zwischen den beiden Elektroden des Kreuzungspunktes angelegt werden, das die Redox-Moleküle wieder reversibel in den niedrigeren (oder höheren) Oxidationszustand zurückversetzt, so dass die Moleküle wieder unlöslich und damit nicht mobil im Dielektrikum werden und beim Anlegen von einem "normalen" niedrigen Auslesepotential des Speicher-Zustands, wiederum keine Redox-Cycling-Reaktion an diesem Kreuzungspunkt mehr stattfinden kann. Die Redox-Moleküle für RW-Speicherzellen müssen entsprechend reversibel oxidierbar sein. In dem ersten Oxidationszustand sind die Redox-Moleküle nicht lösbar und können nicht zwischen den Elektroden diffundieren. Sie sollen dann auch einen höheren zweiten reversiblen Oxidations- oder Reduktionszustand haben, um ausgelesen zu werden. Beispielweise kann hierzu Ferrocen- (nicht löslich in Wasser) und deren Derivative wie Ferrocenmethanol (löslich in Wasser) verwendet werden, die reversibel aus einem Zustand in den überführt werden können.

3.b. Multi-level RW: Dieses Speicherarray wird wie in 3.a. gezeigt bereit gestellt, aber mit mehreren Konzentrationen von Redox-Molekülen, z. B. mit bis zu 16 verschiedenen Konzentrationen für die Erzeugung von hexadezimalen Speicherzellen. Die verschiedenen Konzentrationen an redoxaktiven Molekülen werden wie bei der WORM-Speicherzelle durch Schreiben erzeugt. Bei der Herstellung wird das Dielektrikum mit höchster Konzentration an redoxaktiven Molekülen bereitgestellt.

Folgende Auslese- und Schreibmodi sind möglich, siehe die auszugsweise gezeigten Beispiele in der Tabelle 5b und die Figur 1c:

**Tabelle 5b: Multi-level RW (HEX), beispielsweise (nicht alle 16 Zustände sind wiedergegeben): Auslesen 1 - vor dem Schreiben; Auslesen 2 - nach dem Schreiben; Auslesen 3 - nach dem Umschreiben; Schreiben - Spannungspuls mit bestimmten Parameter; Umschreiben - umgekehrter Spannungspuls mit bestimmten Parameter; Default - alle Zellen "1".**

| Modus | Redox-Molekül Konzentration (diskret) | Potential Kathode | Potential Anode | Stromwert (diskret) | Speicher-zellenwert |
|---|---|---|---|---|---|
| Stillstand | [A+B] = 15 | keine | keine | keine | ? |
| Auslesen 1 | [A+B] = 15 | V_{Auslesen(red)} | V_{Auslesen(ox)} | 16 | "F" |

| Reversibles Schreiben 1 durch Reduktion | | | | | |
|---|---|---|---|---|---|
| Schreiben | [A+B] = 3 | V_{Schreiben(red)} | GND | - | - |
| Auslesen 2 | [A+B] = 3 | V_{Auslesen(red)} | V_{Auslesen(ox)} | 4 | "3" |

| oder reversibles Schreiben 1 durch Oxidation | | | | | |
|---|---|---|---|---|---|
| Schreiben | [A+B] = 3 | GND | V_{Schreiben(ox)} | - | - |
| Auslesen 2 | [A+B] = 3 | V_{Auslesen(red)} | V_{Auslesen(ox)} | 4 | "3" |

| Umschreiben durch Wiederoxidation (nach Reduktion) | | | | | |
|---|---|---|---|---|---|
| Umschreiben | [A+B] = 11 | GND | V_{Schreiben(ox)} | - | - |
| Auslesen 3 | [A+B] = 11 | V_{Auslesen(red)} | V_{Auslesen(ox)} | 12 | "B" |

| Umschreiben durch Wiederreduktion (nach Oxidation) | | | | | |
|---|---|---|---|---|---|
| Umschreiben | [A+B] = 11 | V_{Schreiben(red)} | GND | - | - |
| Auslesen 3 | [A+B] = 11 | V_{Auslesen(red)} | V_{Auslesen(ox)} | 12 | "B" |

Es wird also beispielweise die RW-Speicherzelle mit einer großen Konzentration an redoxaktivem Molekül im Dielektrikum hergestellt. Ein erster Schreibvorgang wird durch Anlegen des Schreibpotentials herbeigeführt und schreibt das redoxaktive Molekül reversibel um, bis es eine geringere Konzentration an [A+B] aufweist, hier die diskrete Konzentration 3. Der erste Schreibvorgang erfolgt entweder durch Oxidation oder Reduktion.

Man kann die Zwischenniveaus durch die Form des Schreibpulses einstellen. Beispielweise kann durch die Variierung der Form und der Stärke des Spannungspulses aus dem Wert "1" nur ein Teil der Redox-Moleküle reversibel verändert werden und dadurch eine bestimmte Konzentration erreichen, das heißt die Konzentration der auslesbaren Redox-Moleküle wird verringert.

Danach kann man mit einem passenden Puls die veränderten, nicht auslesbaren Redox-Moleküle wieder zu dem ursprünglichen Zustand, oder in einen anderen Zwischenzustand hier der diskreten Konzentration mit Wert 11 reversibel verändern und die Konzentration der auslesbaren Redox-Moleküle wieder erhöhen.

Es versteht sich, dass die für die ROM-Speicherzellen, WORM-Speicherzellen und RW-Speicherzellen nur schematisch angegebenen Moleküle A und B, sowie gegebenenfalls auch C und D tatsächlich unterschiedlich sein müssen, um die oben beschriebenen Voraussetzungen zu erfüllen. Es gibt also tatsächlich A_{ROM}, B_{ROM}, A_{WORM}, B_{WORM}, C_{WORM}, D_{WORM}, A_{RW}, B_{RW}, C_{RW}, D_{RW}.

Die Speicherzellen ROM, WORM und RW unterscheiden sich also durch chemisch verschiedene redoxaktive Moleküle bzw. Oxidationszustände A_{ROM}, B_{ROM}, A_{WORM}, B_{WORM}, C_{WORM}, D_{WORM}, A_{RW}, B_{RW}, C_{RW}, O_{RW}, wobei die zyklische Reaktion zur Generierung von Strom oberhalb des Schwellwerts und damit Speicherzustand 1 zwischen A ↔ B stattfindet, wie unter anderem in den Ausführungsbeispielen angegeben.

Die Speicherzellen WORM und RW unterscheiden sich also ebenfalls durch chemisch verschiedene mittels Schreibpotential erzeugbare Moleküle C und D.

Die erfindungsgemäßen Speicher(arrays) werden als nicht volatile Speicher zum Erzeugen von bits und bytes auf binärer oder hexadezimaler Basis oder jeder anderen Basis verwendet.

Auch die Tinte zur Herstellung eines derartigen Speichers löst bereits die Aufgabe der Erfindung. Die Tinte umfasst hierzu die Precursor einer Sol-Gel-Reaktion oder für Hydrogele und die redoxaktiven Moleküle, die durch Trocknen, bzw. Aushärten der Tinte auf der Leiterbahn zwischen den Elektroden diffundieren können, entweder sofort als Default "1" oder nach Anlegen eines Spannungspulses, der die Moleküle im Dielektrikum löslich werden lässt (Default "0").

Als Tinten kann jede flüssige Zusammensetzung, die insbesondere mit einem Druck-verfahren angeordnet werden kann, verwendet werden, die nach der Deposition eine dielektrische Schicht, vorzugsweise mit redoxaktiven Molekülen, und welche die Diffusion der redoxaktiven Moleküle ermöglicht. Die Diffusion verläuft durch die Nanoporen des nanoporösen Dielektrikums. Die Porengröße soll hierzu größer als die Molekülgröße redoxaktiver Moleküle sein. Bei den üblichen Größen der redoxaktiven Moleküle von etwa 1 - 5 nm, soll die Porengröße z. B. mindestens 2 - 10 nm oder mehr betragen (Faktor 2). Falls die dielektrische Schicht eine feste aber quasiflüssige Phase aufweist wie beim Hydrogel, verläuft die Diffusion direkt durch diese Phase.

Unabhängig von dem physikalischen Wirkprinzip, soll die Diffusionskonstante der redoxaktiven Moleküle bei Diffusion durch die Poren möglichst ähnlich sein zu der Diffusionskonstante in der flüssigen Phase ohne Poren und mindestens 1 % hiervon oder besser betragen, z. B. mindestens 5 %, 10 %, 15 %, 20 %, 30 %, 40 %, 50 %, 60 %, 70 %, 80 %, 90 % oder sogar 100 %.

Nach der erfindungsgemäßen Definition für die redoxaktiven Moleküle handelt es sich bei diesen nicht um Enzyme.

Die Tinte soll einen Festanteil haben, damit die Schichtdicke der dielektrischen Schicht nach dem Drucken und Trocknen etwa 50 -1000 nm, am besten 100 - 300 nm aufweist.

Vorzugsweise werden die nanoporösen Dielektrika zwischen den Elektroden mit den angegebenen Bestandteilen nach dem Druck auf die erste Leiterbahn hergestellt. Hierzu umfasst die Tinte vorteilhaft die Ausgangsbestandteile für eine Sol-Gel-Reaktion, z. B. Tetramethylorthosilicat, Tetraethoxysilan und so weiter). Im ersten Schritt erfolgt die Hydrolyse in Wasser und Alkohol und sodann in einem weiteren Schritt die Kondensation zur Sol-Gel-Matrix mit Restflüssigkeit.

Die Tinte weist hierfür vorzugsweise ein Lösemittel mit niedrigem Dampfdruck und entsprechend hohem Siedepunkt auf.

### Ausführungsbeispiele

Im Weiteren wird die Erfindung an Hand von Ausführungsbeispielen und der beigefügten Figuren näher erläutert, ohne dass es hierdurch zu einer Beschränkung der Erfindung kommen soll.

Es zeigen:
- Figur 1:: Abhängigkeit des gemessenen Redox-Cycling-Stroms von der angelegten Spannung, dargestellt durch zyklische Voltammograme der verwendeten redoxaktiven Moleküle. a) ROM; b) WORM und c) RW.
- Figur 2:: Schematische Darstellung erfindungsgemäßer Speicherarray a) ROM binär. b) WORM/RW binär. c) Multi-level ROM/WORM/RW
- Figur 3:: Verfahren zur Herstellung eines Speicherarray (ROM/WORM/RW)
- Figur 4:: Abhängigkeit des gemessenen CV-Voltammogram von der Konzentration der redoxaktiven Moleküle, hier am Beispiel von Ferrocendimethanol.

Figur 1a) zeigt das zyklische Voltammogram einer ROM Zelle. Figur 1 b) zeigt das zyklische Voltammogram einer WORM Zelle. Figur 1 c) zeigt das zyklische Voltammogram einer RW Zelle. Die Modi zum Beschreiben und Auslesen sind den Beschreibungen zu den Tabellen 3 bis 5 zu entnehmen.

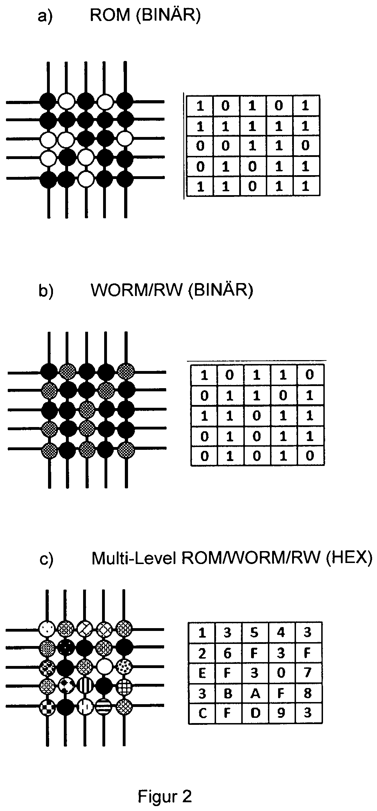

Figur 2a zeigt schematisch die Anordnung der nanoporösen Dielektrika an 16 Kreuzungspunkten zwischen den Elektroden in einem ROM-Speicherarray, binär. Die Speicherzustände - hier nur "0" und "1" sind rechts daneben wieder gegeben. Es sind entsprechend der ROM nur die Zustände "0" und "1" möglich, siehe die Tabelle 3a. Helle Kreise betreffen die Speicherzellen ohne redoxaktive Moleküle, ausgefüllte Kreise hingegen Speicherzellen mit redoxaktiven Molekülen, das heißt solche in denen Strom erzeugt werden kann.

Figur 2b zeigt schematisch die Anordnung der nanoporösen Dielektrika an 16 Kreuzungspunkten zwischen den Elektroden in einem WORM- bzw. RW-Speicherarray. Die Speicherzustände - hier nur "0" und "1" (Binär) sind rechts daneben angegeben, siehe die Tabellen 4a und 5a. Die schwarz ausgefüllten Kreise symbolisieren die Speicherzellen mit redoxaktiven Moleküle, in denen Strom erzeugt werden kann, die grau unterlegten Kreise die Speicherzellen ohne ausreichenden Strom.

Figur 2c zeigt schematisch die Anordnung von nanoporösen Dielektrika an 16 Kreuzungspunkten zwischen den Elektroden in einem Multilevel-ROM/WORM- bzw. RW-Speicherarray. Die unterschiedlichen Speicherzustände, - von "0" bis "F" - sind rechts daneben angegeben. Diese Speicherzustände werden im linken Teil der Figur durch die unterschiedliche Schraffur an den Kreuzungspunkten und damit durch die verschiedenen Konzentrationen dargestellt.

### Ausführungsbeispiel 1:

25-Bit (binär) gedrucktes Redox-Cycling-basiertes elektrochemisches ROM-Speichermodul (Figuren 1a, 2a und 3 bis 4).

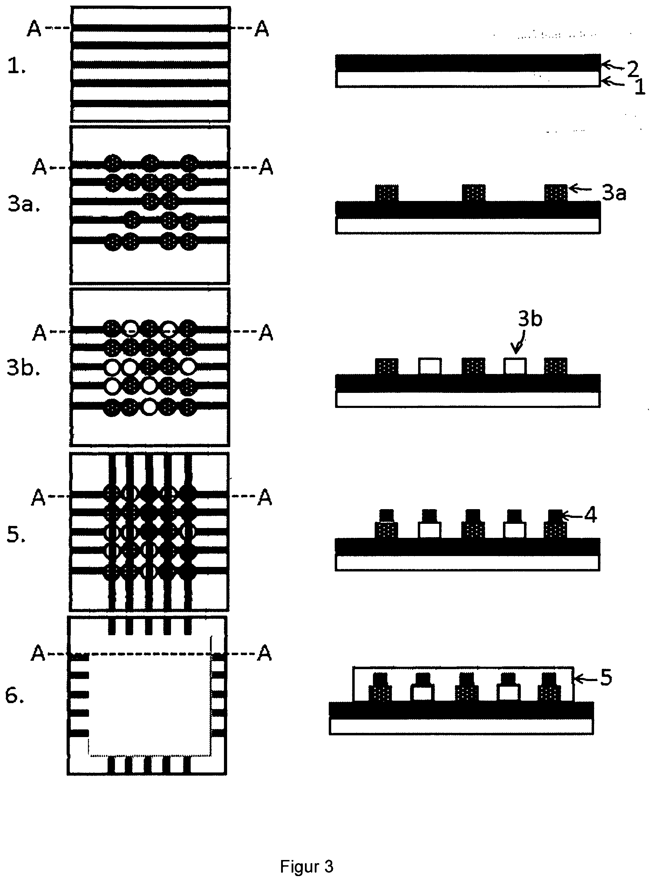

Figur 2a zeigt schematisch die Anordnung des ROM-Speicherarray im fertigen Zustand. Figur 3 zeigt das zugehörige Herstellungs-Verfahren in Aufsicht links und im Schnitt entsprechend der Linie A-A rechts in der Figur. Aus Platzgründen ist in der Figur 3 nur jeweils eine Struktur mit einem Bezugszeichen versehen worden.
1. Goldtinte wird als Material für die erste Leiterbahn 2 bzw. für die untere Elektrode benutzt. Die leitenden Strukturen 2, dargestellt durch insgesamt fünf Linien (100 µm breit, 100 µm Abstand zwischen den Leiterbahnen) aus der Goldtinte werden auf einem PEN (Polyethylennaphthalat)-Substrat 1 mit einem Tintenstrahldrucker gedruckt und danach bei 125 °C für 1 Stunde gesintert.
2. Zwei Sol-Gel-Tinten werden vorbereitet:
   a. Ohne Redox-Moleküle: TMOS (Tetramethylorthosilicat) wird 1:1:1 (Gewichtsanteile) mit deionisiertem Wasser und Glyzerol in einer 100 mL Flasche gemischt und eine Stunde lang mit einem magnetischen Rührer auf einer Magnetplatte bei Raumtemperatur gerührt. Danach wird 100 mM-Lösung der Salzsäure im 500:1 (Sol-Gel:Säure, Gewichtsanteile) für den Start der Kondensationsreaktion dazu gegeben.
   b. Mit Redox-Moleküle: Eine 1 mM-Lösung einer Mischung Redox-Moleküle Hexacyanoferrat (II) / Hexacyanoferrat (III) (Normalpotential +200 mV gegen Kalomelelektrode SCE) wird im deionisiertem Wasser vorbereitet. TMOS wird 1:1:1 (Gewichtsanteile) mit der Ferrocendimethanollösung und Glyzerol in einer 100 mL Flasche gemischt und eine Stunde lang mit magnetischem Rührer auf einer Magnetplatte bei Raumtemperatur gerührt. Danach wird 100 mM-Lösung der Salzsäure im 500:1 (Sol-Gel:Säure, Gewichtsanteile) für den Start der Kondensationsreaktion dazu gegeben. Bei Bedarf wird eine 10-100 mM Salzlösung (z.B. NaCl) dazu gegeben, um die elektrische Leitfähigkeit der Schicht und Elektronentransfer zu verbessern.
3. Die Sol-Gel-Tinten werden auf den zukünftigen Kreuzungspunkten gedruckt. An Stellen, an denen ein Zustand "1" (Figur 3b) ausgelesen werden soll, wird die Tinte mit den Redox-Molekülen für das nanoporöse Dielektrikum 3a gedruckt, dargestellt durch die dunklen Kreise im linken Teil der Figur 3b. An den Stellen, an denen der Zustand "0" ausgelesen werden soll, wird die Tinte ohne Redox-Moleküle gedruckt für das nanoporöse Dielektrikum 3b, dargestellt durch die nicht ausgefüllten Kreise.
4. Nach dem Drucken der nanoporösen Dielektrika 3a, 3b wird die gedruckte Tinte bei Raumtemperatur für eine Stunde ausgehärtet, so dass die gedruckten Dielektrika noch Rest-Flüssigkeit enthalten.
   Entsprechend bildet sich das punktförmige nanoporöse Dielektrikum mit (Bezugszeichen 3a) und ohne (Bezugszeichen 3b) ein redoxaktives Molekül.
5. Karbontinte aus 300-400 nm großen Kohlenstoffnanopartikeln wird als Material für die zweite Leiterbahn 4 bzw. die obere Elektrode benutzt. Diese Tinte wird orthogonal zu den ersten Leiterbahnen 2 über die nanoporösen Dielektrika gedruckt um die "cross-bar"-Struktur (Matrix) und die Kontaktstellen zu formen. Insgesamt sind wie für die Leiterbahn 2 wiederum fünf Leiterbahnen bzw. Elektroden 4 gezeigt. Die Tinte wird nach dem Druck bei 125° C für 1 Stunde gesintert.
6. Als Passivierungsschicht 5 wird eine Schicht aus Polyimid großflächig aufgebracht, z. B. gedruckt, so dass nur die Kontaktstellen am Ende der Elektroden offen bzw. kontaktierbar bleiben, wie in der Figur 3 im linken Teil gezeigt.
7. Um den Speicher auszulesen, werden alle Elektroden gleichzeitig oder eine nach der anderen (durch einen Schalter) kontaktiert. Bei jedem Kreuzungspunkt wird auf der unteren Elektrode ein Potential von 0 mV gegen Masse angelegt, während auf der oberen Elektrode ein Potential von +300 mV gegen Masse angelegt wird. Die Referenzelektrode entfällt in diesem Design und der Strom wird ohne Referenzelektrode gegen Masse gemessen. Wenn der ausgelesene Strom einen bestimmten Stromwert (abhängig von dem Zellendesign und der Konzentration der Redox-Moleküle, für diese Beispiel ca. 40 pA) nach einer bestimmten Zeit (abhängig vom Zellendesign, für dieses Beispiel ca. 3 ms) überschreitet, wird diese Zelle als Zustand "1" identifiziert. Wenn nicht, wird sie als Zustand "0" identifiziert.

### Ausführungsbeispiel 2:

Ein 25-Bit (HEX) gedrucktes Redox-cycling-basiertes elektrochemisches ROM-Speichermodul (Figur 1a, Figur 2c, Figur 3)) wird hergestellt.

Die Schritte 1 bis 6 entsprechen denen des Ausführungsbeispiels 1. Es werden aber bis zu 16 verschiedene Tinten mit bis zu 16 verschiedenen Konzentrationen an Redox-Molekülen bereitgestellt. Es werden auf diese Weise 16 Tinten mit 16 Konzentrationen von z. B. 0 µM, 1 µM, 5 µM, 10 µM, 25 µM, 50 µM, 100 µM, 200 µM, 300 µM, 400 µM, 500 µM, 600 µM, 700 µM, 800 µM, 900 µM, 1000 µM) der Redox-Moleküle Hexacyanoferrat (II)/Hexacyanoferrat (III) vorbereitet. Die Konzentrationen sind in der Figur 2c mit Kreisen mit unterschiedlichen Füllungen dargestellt.

Diese Tinten werden durch mehrere Druckköpfe bzw. Düsen in die Kreuzungspunkte des Speicher-Arrays als dielektrische nanoporöse Schicht 3 nacheinander gedruckt um 25-Bit (HEX) Speichermodule zu erzeugen.

7. Um den Speicher auszulesen, werden alle Elektroden gleichzeitig oder eine nach der anderen (durch einen Schalter) kontaktiert. Bei jedem Kreuzungspunkt wird auf der unteren Elektrode 2 ein Potential von -300 mV gegen Masse angelegt, während auf der oberen Elektrode 4 ein Potential von +300 mV gegen Masse angelegt wird. Die Referenzelektrode entfällt in diesem Design und der Strom wird ohne Referenzelektrode gegen Masse gemessen. Der ausgelesene Strom nach einer bestimmten Zeit (abhängig von dem Zellendesign, für dieses Beispiel ca. 3 ms) wird zu einer bestimmten Konzentration (aus 16 vorkalibrierten Stromwerten insgesamt, siehe auch die Figur 4) zugeordnet um den Speicherzustand der Zelle auszulesen. Es sind dann Zustände zwischen "0" und "F" (0, 1, 2, 3, 4, 5, 6, 7, 8, 9, A, B, C, D, E, F) möglich.

Beispielhaft ist in der Figur 4 gezeigt, dass die gemessenen Ströme den Konzentrationen zum Auslesen der 16 Zustände zugeordnet werden können.

### Ausführungsbeispiel 3:

Ein 25-Bit (binär) gedruckter redox-cycling-basierter elektrochemischer WORM-Speichermodul (Figur 1b, Figur 2b, Figur 3) wird hergestellt.

Schritte 1-7 entsprechen denen aus dem Ausführungsbeispiel 1. Die Unterschiede liegen in den Schritten 2 und 3, und es erfolgt noch ein Schritt 6*:
1. Wie Ausführungsbeispiel 1, aber Schritt 2a entfällt. Jedes nanoporöse Dielektrikum enthält also Tinte mit redoxaktiven Molekülen. In Schritt 2b wird Heptylviologenbromid mit einem Normalpotential der ersten reversiblen Reduktionsreaktion von -300 mV und einem Normalpotential der zweiten irreversiblen Reduktionsreaktion von-700 mV anstatt Hexacyanoferrat (II)/Hexacyanoferrat (III) Mischung verwendet.
2. Diese Sol-Gel-Tinte wird auf allen zukünftigen Kreuzungspunkten gedruckt um den Default "1" zu bilden (Schritt 3.).

Vor dem Schritt 7 erfolgt kann gegebenenfalls ein irreversibler Schreibschritt erfolgen:
6*. Um aus dem Zustand "1" Zustand "0" an einigen bestimmten Kreuzungspunkten (Speicherzellen aus dem Array) zu erzeugen, wird zwischen der oberen und unteren Elektrode an diesen Kreuzungspunkten ein Reduktionspotential von -1 V für 1 Sekunde angelegt. Das angelegte Potential reicht aus, um die irreversible Reaktion A→ D zu treiben. Danach sind die Moleküle in dem Bereich von Auslesepotentialen im Sinne der Redoxreaktion A ↔ B nicht mehr redoxaktiv. Stattdessen liegen die redoxaktiven Moleküle in der inaktiven reduzierten Form D vor.
7. Wie in Ausführungsbeispiel 1.

### Ausführungsbeispiel 4:

Ein 25-Bit (binär) gedrucktes Redox-cycling-basiertes elektrochemisches RW-Speichermodul (Figur 1c, Figur 2b, Figur 3) wird hergestellt.

Die Schritte 1 und 3-5 sowie 7 entsprechen denen aus dem Ausführungsbeispiel 3. Der Unterschied liegt in den Schritten 2 und 6*, hinzu kommt noch ein Schritt 8:
2. An Stelle von Heptylviologenbromid wird Azotoluen der ersten reversiblen Oxidationsreaktion von +300 mV und einem Normalpotential der zweiten reversiblen Reduktionsreaktion von +700 mV verwendet. Nach dem Aufbringen der Tinte mit dem redoxaktiven Molekül weisen alle Speicherzellen den Default "1" auf.
6*. Um aus dem Zustand "1" einen Zustand "0" an bestimmten Kreuzungspunkten bzw. Speicherzellen aus dem Array zu erzeugen, wird zwischen den oberen und den unteren Elektroden an diesen Kreuzungspunkten ein Oxidationspotential von +1,5 V für 1 Sekunde angelegt. Danach sind die Moleküle in dem Bereich vom Auslesepotential der Redoxreaktion A ↔ B nicht mehr redoxaktiv, da Molekül C erzeugt wurde. Es kann alternativ auch das Molekül D durch ein entsprechendes Reduktionspotential von -1,5 V erzeugt werden.
8. Um aus dem geschriebenen Zustand "0", wieder den Zustand "1' an bestimmten Kreuzungspunkten zu erhalten, wird zwischen den oberen und den unteren Elektroden an diesen Kreuzungspunkt ein umgekehrtes Reduktionspotential (bzw. Oxidationspotential) von -1,5 V für 1 Sekunde angelegt. Danach werden die Moleküle in dem Bereich von Auslesepotentialen der Redoxreaktion A ↔ B wieder redoxaktiv.

### Ausführungsbeispiel 5:

Ein 25-Bit (hexadezimales) gedrucktes Redox-cycling-basiertes elektrochemisches RW-Speichermodul wird hergestellt.

Die Vorgehensweise entspricht Ausführungsbeispiel 2, Schritte 1-6. Einen Unterschied gibt es nur bei den redoxaktiven Molekülen in Schritt 2. Die hier verwendeten Moleküle entsprechen denen aus Schritt 2. im Ausführungsbeispiel 4 (RW Binär Speicher). Um Den Speicher zu schreiben (Schritt 7) wird für einen definierten kurzen Zeitraum ein Schreibpotential angelegt, z. B. für 100 mS. Zum Verringern des gespeicherten Zustandes wird ein Oxidationspotential angelegt, sodass ein Teil der Partikel in einen reversiblen, höheren Oxidationszustand überführt wird (B→C). Zum Erhöhen des gespeicherten Zustandes wird ein reduzierendes Potential angelegt, sodass ein Teil der Partikel aus dem höheren in den niedrigeren Zustand überführt wird (C→ B) und wieder für das Redox-Cycling zur Verfügung steht. Dieser Prozess kann auch in Richtung einer zweiten Reduktion erfolgen. Die Potentiale werden hierfür genau umgekehrt angelegt. Das Auslesen erfolgt dann analog zu Schritt 7, Ausführungsbeispiel 2.

### Weitere Ausführungsbeispiele:

Weitere Ausführungsbeispiele betreffen die Herstellung und Verwendung derartiger Speicherzellen für die Lebensmittelindustrie. Die in den Ausführungsbeispielen, und insbesondere in den Ausführungsbeispielen 1 und 2 offenbarten ROM-Speicherzellen sind insbesondere geeignet für die Herstellung von gedruckten Speicherzellen auf Umverpackungen in der Lebensmittelindustrie. Der Grund liegt darin, dass die Redox-Moleküle, wie beispielweise das Hexacyanoferrat (II) / Hexacyanoferrat (III) weitgehend lebensmittelunbedenklich sind, insbesondere dann, wenn sie auf der Oberfläche der die Lebensmittel enthaltenden Kartonagen oder anderer Umverpackungen angeordnet sind.

Derartige ROM-Speicherzellen können dann genutzt werden, um Informationen über die Lebensmittel, wie das Herstellungsdatum, das Ablaufdatum, das Abfülldatum der Lebensmittel und weitere relevanten Parameter wie z. B. Herkunft der Lebensmittel oder Transportwege usw. während der Herstellung abzuspeichern und auf einfache Weise auch wieder auszulesen.

Es ist denkbar, für das Auslesen auch ohne elektronische Zuleitungen die notwendige Spannung an die Speicherzelle anzulegen und die entsprechenden Parameter wieder auszulesen, z. B. über Radiowellen, wie bei einem RFID-Tag.

Das erfindungsgemäße Verfahren kann hierzu ausgeführt werden, indem als nicht leitendes Substrat ein Bestandteil einer solchen Kartonage bereitgestellt wird.

Die erfindungsgemäße Verwendung der Speicherzellen betrifft dann das zusätzliche Merkmal, wonach diese Speicherzelle auf einer Umverpackung aus der Lebensmittelindustrie angeordnet wird. Die Speicherzelle könnte auch auf der Verpackung aufgeklebt sein.

## Patentansprüche

1. **Verfahren zur Herstellung einer Speicherzelle,**
**gekennzeichnet durch** die Schritte:
a) ein nicht leitendes Substrat (1) wird bereit gestellt;
b) eine erste Leiterbahn (2) aus einem leitenden Material wird auf dem Substrat angeordnet;
c) auf die erste Leiterbahn wird punktförmig eine Sol-Gel-Tinte oder eine HydrogelTinte für ein poröses Dielektrikum (3a, 3b) angeordnet und derart getrocknet, dass eine nanoporöse Schicht mit Poren umfassend ein Flüssigkeitsvolumen ausgebildet wird, welches redoxaktive Moleküle aufweist;
d) orthogonal zur ersten Leiterbahn wird eine zweite Leiterbahn (4) angeordnet, wobei die erste und die zweite Leiterbahn (2, 4) an ihrem Kreuzungspunkt eine Elektrodenfunktion aufweisen, und zwischen den Elektroden das Dielektrikum (3a, 3b) angeordnet vorliegt;
e) auf das Substrat, die erste Leiterbahn, das Dielektrikum und die zweite Leiterbahn wird eine Passivierungsschicht (5) angeordnet, so dass die Leiterbahnen kontaktierbar bleiben;
wobei die erste und die zweite Leiterbahn an ihrem Kreuzungspunkt mit dem dazwischen angeordneten Dielektrikum einen Speicher ausbilden, in dem durch Anlegen von Spannung über die Leiterbahnen die Redoxreaktion der redoxaktiven Moleküle an den Elektroden getrieben wird zur Erzeugung eines Speicherzustands.

2. Verfahren nach Anspruch 1,
**dadurch gekennzeichnet, dass**
die erste Leiterbahn und/oder das Dielektrikum und/oder die zweite Leiterbahn und/oder die Passivierungsschicht mit einem Druckverfahren angeordnet werden.

3. Verfahren nach dem vorherigen Anspruch,
**gekennzeichnet durch**
die Wahl einer Tinte, welche redoxaktive Moleküle umfasst, die nach der Ausbildung des nanoporösen Dielektrikums in den Poren des Dielektrikums an die Elektroden diffundieren und an diesen umgesetzt werden können.

4. Verfahren nach einem der vorherigen Ansprüche,
**gekennzeichnet durch**
Wiederholung der Schritte zur Ausbildung einer Vielzahl an orthogonal zueinander angeordneten Leiterbahnen in einem Speicherarray.

5. Verfahren nach dem vorherigen Anspruch,
**gekennzeichnet durch**
Wahl von Tinte mit unterschiedlichen Konzentrationen und/oder Substanzen an redoxaktiven Molekülen für das Speicherarray.

6. **Speicherzelle,** umfassend mindestens eine Anordnung aus
- einer ersten elektrisch kontaktierbaren Leiterbahn (2) auf einem nicht leitenden Substrat (1),
- einer orthogonal hierzu angeordneten zweiten elektrisch kontaktierbaren Leiterbahn (4),
- wobei die Leiterbahnen am Kreuzungspunkt Elektrodenfunktion aufweisen und
- wobei am Kreuzungspunkt zwischen den beiden Leiterbahnen ein poröses Dielektrikum (3a, 3b) mit einem in den Poren befindlichen Flüssigkeitsvolumen umfassend frei in den Poren diffundierbare redoxaktive Moleküle angeordnet ist,
- welche an den Elektroden der Leiterbahnen durch Anlegen von elektrischer Spannung zur Erzeugung von Speicherzuständen oxidiert und/oder reduziert werden können und
- wobei der Speicher aus Substrat, Leiterbahnen und Dielektrikum vollständig durch eine Passivierungsschicht (5) passiviert ist.

7. Speicherarray mit einer Vielzahl passivierter elektrochemischer Speicherzellen nach vorherigem Anspruch in einer "crossbar"-Konfiguration.

8. Speicherarray nach dem vorherigen Anspruch,
**gekennzeichnet dadurch, dass**
verschiedene Speicherzellen des Speicherarray mehrere verschiedene redoxaktive Moleküle und/oder verschiedene Konzentrationen an einem redoxaktiven Molekül aufweisen.

9. ROM-Speicherarray nach einem der vorherigen Ansprüche 7 oder 8,
**gekennzeichnet durch**
eine Vielzahl an nanoporösen Dielektrika (3b) ohne redoxaktive Moleküle und eine Vielzahl an nanoporösen Dielektrika (3a) mit einem redoxaktiven Molekül, wobei das redoxaktive Molekül reversibel ausschließlich zwischen seinen zwei Oxidationszuständen gemäß einer Reaktion A ↔ B oxidiert und reduziert werden kann.

10. WORM-Speicherarray nach einem der vorherigen Ansprüche 7 oder 8
**gekennzeichnet durch**
eine Vielzahl an nanoporösen Dielektrika (3a) mit einem redoxaktiven Molekül, wobei das redoxaktive Molekül reversibel zwischen seinen zwei Oxidationszuständen A und B gemäß einer ersten Reaktion A ↔ B oxidiert und reduziert werden kann und bei dem das redoxaktive Molekül zusätzlich mindestens einen weiteren irreversiblen Oxidationszustand gemäß einer zweiten irreversiblen Reaktion B → C und/oder einer dritten irreversiblen Reaktion A → D aufweist.

11. RW-Speicherarray nach einem der vorherigen Ansprüche 7 oder 8,
**gekennzeichnet durch**
eine Vielzahl an nanoporösen Dielektrika (3a) mit einem redoxaktiven Molekül, wobei das redoxaktive Molekül reversibel zwischen seinen zwei Oxidationszuständen A und
B gemäß einer ersten Reaktion A ↔ B oxidiert und reduziert werden kann und bei dem das redoxaktive Molekül zusätzlich mindestens einen weiteren reversiblen Oxidationszustand gemäß einer zweiten reversiblen Reaktion B ↔ C und/oder einer dritten reversiblen Reaktion A ↔ D aufweist.

12. **Verwendung eines ROM-Speicherarrays nach Anspruch 9,**
wobei das redoxaktive Molekül durch Anlegen von Spannung an die Elektroden mit einem Auslesepotential oberhalb und unterhalb des Normalpotentials des redoxaktiven Moleküls reversibel gemäß der Reaktion A ↔ B oxidiert und reduziert wird und der gemessene Strom bei Überschreiten eines Schwellwerts als Zustand "1" ausgelesen wird und bei dem der Zustand 0 ausgelesen wird für Speicherzellen ohne redoxaktive Moleküle.

13. Verwendung eines WORM-Speicherarray nach Anspruch 10,
wobei das redoxaktive Molekül durch Anlegen von Spannung an die Elektroden mit einem Auslesepotential oberhalb und unterhalb des Normalpotentials des redoxaktiven Moleküls gemäß der Reaktion A ↔ B reversibel oxidiert und reduziert wird und der gemessene Strom bei Überschreiten eines Schwellwerts als Zustand 1 ausgelesen wird.

14. Verwendung eines WORM-Speicherarray nach dem vorherigen Anspruch,
wobei das redoxaktive Molekül durch Anlegen von Spannung an die Elektroden mit einem Schreibpotential in den irreversiblen Oxidationszustand gemäß der Reaktion B → C oder A → D umgeschrieben wird, so dass das redoxaktive Molekül durch Anlegen von Spannung an die Elektroden mit einem Auslesepotential oberhalb und unterhalb des Normalpotentials des redoxaktiven Moleküls gemäß der Reaktion A ↔ B nicht mehr oxidiert oder reduziert wird und der gemessene Strom als Zustand 0 ausgelesen wird.

15. Verwendung eines RW-Speicherarray nach Anspruch 11,
wobei das redoxaktive Molekül durch Anlegen von Spannung an die Elektroden mit einem Auslesepotential oberhalb und unterhalb des Normalpotentials des redoxaktiven Moleküls gemäß der Reaktion A ↔ B reversibel oxidiert und reduziert wird und der gemessene Strom bei Überschreiten des Schwellwerts als Zustand 1 ausgelesen wird.

16. Verwendung eines RW-Speicherarray nach dem vorherigen Anspruch,
wobei das redoxaktive Molekül durch Anlegen von Spannung an die Elektroden mit einem Schreibpotential in den reversiblen Oxidationszustand gemäß der Reaktion B ↔ C oder A ↔ D umgeschrieben wird, so dass das redoxaktive Molekül durch Anlegen von Spannung an die Elektroden mit einem Auslesepotential oberhalb und unterhalb des Normalpotentials des redoxaktiven Moleküls gemäß der Reaktion A ↔ B nicht mehr oxidiert oder reduziert wird und der gemessene Strom als Zustand 0 ausgelesen wird.

17. Verwendung eines RW-Speicherarray nach den zwei vorherigen Ansprüchen,
**gekennzeichnet dadurch, dass**
das redoxaktive Molekül durch Anlegen von Spannung an die Elektroden in den reversiblen Oxidationszustand gemäß der Reaktion A ↔ B umgeschrieben wird, so dass das redoxaktive Molekül durch Anlegen von Spannung an die Elektroden mit einem Auslesepotential oberhalb und unterhalb des Normalpotentials des redoxaktiven Moleküls gemäß der Reaktion A ↔ B wieder reversibel oxidiert und reduziert wird und der gemessene Strom bei Überschreiten des Schwellwerts als Zustand 1 ausgelesen wird.

18. Verwendung eines Speicherarray nach einem der vorherigen Ansprüche 12 bis 17,
**dadurch gekennzeichnet, dass**
für ROM-Speicherarray eine Vielzahl an Speicherzellen mit verschiedenen Konzentrationen an redoxaktiven Molekülen in den Dielektrika bereit gestellt und über die Elektroden durch Auslesepotentiale angesprochen und der gemessene Strom bei Überschreiten des Schwellwerts unterschiedlichen Speicherzuständen entsprechend der Konzentrationen zugeordnet wird und für RW-Speicherarray und WORM-Speicherarray eine Vielzahl an Speicherzellen mit verschiedenen Konzentrationen an redoxaktiven Molekülen in den Dielektrika durch Schreibpotentiale reversibel (RW) oder irreversibel (WORM) erzeugt werden, und die Elektroden durch Auslesepotentiale angesprochen und der gemessene Strom unterschiedlichen Speicherzuständen bei Überschreiten des Schwellwerts zugeordnet wird.

## Claims

1. Process for manufacturing a memory cell,
**characterized by** the steps:
a) a non-conductive substrate (1) is provided;
b) a first conductor track (2) of a conductive material is arranged on the substrate;
c) a sol-gel ink or a hydrogel ink for a porous dielectric (3a, 3b) is arranged in a punctiform manner on the first conductor track and is dried in such a way that a nanoporous layer having pores comprising a liquid volume is formed, which has redox-active molecules;
d) a second conductor track (4) is arranged orthogonally to the first conductor track, wherein the first and the second conductor tracks (2, 4) have an electrode function at their crossing point, and the dielectric (3a, 3b) is provided arranged between the electrodes;
e) a passivation layer (5) is arranged on the substrate, the first conductor track, the dielectric and the second conductor track, such that the conductor tracks remain contactable; wherein the first and the second conductor tracks form a memory at their crossing point, with the dielectric arranged therebetween, in which memory the redox reaction of the redox-active molecules on the electrodes is driven by applying voltage via the conductor tracks in order to generate a memory state.

2. The method according to claim 1,
**characterized in that**
the first conductor track and/or the dielectric and/or the second conductor track and/or the passivation layer are arranged with a printing method.

3. The method according to the preceding claim,
**characterized by**
the selection of an ink comprising redox-active molecules which, after the formation of the nanoporous dielectric in the pores of the dielectric, diffuse to the electrodes and can be converted to the latter.

4. The method according to any of the preceding claims,
**characterized by**
repetition of the steps for forming a plurality of conductor tracks arranged orthogonally with respect to one another in a memory array.

5. The method according to the preceding claim,
**characterized by**
selection of ink with different concentrations and/or substances on redox-active molecules for the memory array.

6. Memory cell, comprising at least one arrangement of
- a first electrically contactable conductor track (2) on a non-conductive substrate (1),
- a second electrically contactable conductor track (4) arranged orthogonally thereto,
- wherein the conductor tracks have an electrode function at the crossing point, and
- wherein a porous dielectric (3a, 3b) having a liquid volume located in the pores and comprising redox-active molecules freely diffusible in the pores, is arranged at the crossing point between the two conductor tracks,
- which can be oxidized and/or reduced at the electrodes of the conductor tracks by applying electrical voltage in order to generate memory states, and
- wherein the memory consisting of substrate, conductor tracks and dielectric is completely passivated by a passivation layer (5).

7. Memory array having a plurality of passivated electrochemical memory cells according to the preceding claim, in a "crossbar" configuration.

8. The memory array according to the preceding claim,
**characterized in that**
different memory cells of the memory array have several different redox-active molecules and/or different concentrations of a redox-active molecule.

9. ROM memory array according to any of the preceding claims 7 or 8,
**characterized by**
a plurality of nanoporous dielectrics (3b) without redox-active molecules and a plurality of nanoporous dielectrics (3a) with a redox-active molecule, wherein the redox-active molecule can be reversibly oxidized and reduced exclusively between its two oxidation states according to a reaction A ↔ B.

10. WORM memory array according to any of the preceding claims 7 or 8,
**characterized by**
a plurality of nanoporous dielectrics (3a) with a redox-active molecule, wherein the redox-active molecule can be reversibly oxidized and reduced between its two oxidation states A and B according to a first reaction A ↔ B, and in which the redox-active molecule additionally has at least one further irreversible oxidation state according to a second irreversible reaction B → C and/or a third irreversible reaction A → D.

11. RW memory array according to any of the preceding claims 7 or 8,
**characterized by**
a plurality of nanoporous dielectrics (3a) with a redox-active molecule, wherein the redox-active molecule can be reversibly oxidized and reduced between its two oxidation states A and B according to a first reaction A ↔ B, and in which the redox-active molecule additionally has at least one further reversible oxidation state according to a second reversible reaction B ↔ C and/or a third reversible reaction A ↔ D.

12. Use of a ROM memory array according to claim 9,
wherein the redox-active molecule is reversibly oxidized and reduced by applying voltage to the electrodes with a read-out potential above and below the normal potential of the redox-active molecule, according to the reaction A ↔ B, and the measured current is read out as state "1" when a threshold value is exceeded, and in which state the 0 is read out for memory cells without redox-active molecules.

13. Use of a WORM memory array according to claim 10,
wherein the redox-active molecule is reversibly oxidized and reduced by applying voltage to the electrodes with a read-out potential above and below the normal potential of the redox-active molecule, according to the reaction A ↔ B, and the measured current is read out as state 1 when a threshold value is exceeded.

14. Use of a WORM memory array according to the preceding claim, wherein the redox-active molecule is rewritten by applying voltage to the electrodes with a write potential, into the irreversible oxidation state according to the reaction B → C or A → D, such that the redox-active molecule no longer is oxidized or reduced by applying voltage to the electrodes with a read-out potential above and below the normal potential of the redox-active molecule, according to the reaction A ↔ B, and the measured current is read out as state 0.

15. Use of a RW memory array according to claim 11,
wherein the redox-active molecule is reversibly oxidized and reduced by applying voltage to the electrodes with a read-out potential above and below the normal potential of the redox-active molecule, according to the reaction A ↔ B, and the measured current is read out as state 1 when the threshold value is exceeded.

16. Use of a RW memory array according to the preceding claim, wherein the redox-active molecule is rewritten by applying voltage to the electrodes with a write potential, into the reversible oxidation state according to the reaction B ↔ C or A ↔ D, such that the redox-active molecule no longer is oxidized or reduced by applying voltage to the electrodes with a read-out potential above and below the normal potential of the redox-active molecule, according to the reaction A ↔ B, and the measured current is read out as state 0.

17. Use of a RW memory array according to the two preceding claims,
**characterized in that**
the redox-active molecule is rewritten by applying voltage to the electrodes into the reversible oxidation state according to the reaction A ↔ B, such that the redox-active molecule again is reversibly oxidized and reduced by applying voltage to the electrodes with a read-out potential above and below the normal potential of the redox-active molecule, according to the reaction A ↔ B, and the measured current is read out as state 1 when the threshold value is exceeded.

18. Use of a memory array according to any of the preceding claims 12 to 17,
**characterized in that**
for ROM memory array, a plurality of memory cells with different concentrations of redox-active molecules in the dielectrics is provided and is addressed via the electrodes by read-out potentials, and the measured current is assigned to different memory states according to the concentrations when the threshold value is exceeded, and for RW memory array and WORM memory array, a plurality of memory cells with different concentrations of redox-active molecules in the dielectrics is reversibly (RW) or irreversibly (WORM) generated by write potentials, and the electrodes are addressed by read-out potentials, and the measured current is assigned to different memory states when the threshold value is exceeded.

## Revendications

1. Procédé de fabrication d'une cellule de mémoire, **caractérisé par** les stades :
a) on se procure un substrat (1) non conducteur ;
b) on met sur le substrat une première piste (2) conductrice en un matériau conducteur ;
c) on met sur la piste conductrice, sous forme de points, une encre de sol-gel ou une encre d'hydrogel pour un diélectrique (3a, 3b) poreux et on la sèche, de manière à constituer une couche nanoporeuse ayant des pores comprenant un volume de liquide, qui a des molécules actives du point de vue rédox ;
d) on met, orthogonalement à la première piste conductrice, une deuxième piste (4) conductrice, la première et la deuxièmes pistes (2, 4) conductrices ayant, à leur point de croisement, une fonction d'électrodes et le diélectrique (3a, 3b) est disposé entre les électrodes ;
e) on met une couche (5) de passivation sur le substrat, sur la première piste conductrice, sur le diélectrique et sur la deuxième piste conductrice, de manière à pouvoir mettre encore en contact les pistes conductrices ;
dans lequel la première et la deuxième piste conductrice constituent, à leur point de croisement avec le diélectrique mis entre elles, une mémoire, dans laquelle, par application d'une tension, par l'intermédiaire des pistes conductrices, on met en œuvre la réaction rédox des molécules actives du point de vue rédox sur les électrodes pour produire un état de la mémoire.

2. Procédé suivant la revendication 1,
**caractérisé en ce que**
on met la première piste conductrice et/ou le diélectrique et/ou la deuxième piste conductrice et/ou la couche de passivation par un procédé d'impression.

3. Procédé suivant la revendication précédentes,
**caractérisé par**
le choix d'une encre, qui comprend des molécules actives du point de vue rédox et qui, après la constitution du diélectrique nanoporeux, diffuse dans les pores du diélectrique sur les électrodes et peut y réagir.

4. Procédé suivant l'une des revendications précédentes,
**caractérisé par**
une répétition des stades pour constituer une pluralité de pistes conductrices disposées orthogonalement les unes par rapport aux autres suivant un réseau de mémoire.

5. Procédé suivant la revendication précédentes,
**caractérisé par**
un choix d'encre de concentrations différentes et/ou de substances différentes en molécules actives du point de vue rédox pour le réseau de mémoire.

6. Cellule de mémoire, comprenant au moins un système composé
- d'une première piste (2) conductrice, pouvant être mise en contact électriquement, sur un substrat (1) non conducteur,
- d'une deuxième piste (4) conductrice, pouvant être mise en contact électriquement, mise orthogonalement à celle-ci,
- dans laquelle les pistes conductrices ont une fonction d'électrodes au point de croisement et
- dans laquelle, au point de croisement entre les deux pistes conductrices, est mis un diélectrique (3a, 3b) poreux ayant un volume de liquide se trouvant dans les pores et comprenant des molécules actives du point de vue rédox pouvant diffuser dans les pores,
- qui peuvent être oxydées et/ou réduites sur les électrodes des pistes conductrices, par application d'une tension électrique pour produire des états de la mémoire et
- dans laquelle la mémoire composée du substrat, des pistes conductrices et du diélectrique, est passivée entièrement par une couche (5) de passivation.

7. Réseau de mémoire ayant une pluralité de cellules de mémoire électrochimiques passivées suivant la revendication précédente, suivant une configuration « crossbar ».

8. Réseau de mémoire suivant la revendication précédentes,
**caractérisé en ce que**
diverses cellules de mémoire du réseau de mémoire ont plusieurs molécules actives du point de vue rédox différentes et/ou des concentrations différentes en une molécule active du point de vue r'dox.

9. Réseau de mémoire ROM suivant l'une des revendications 7 ou 8 précédentes,
**caractérisé par**
une pluralité de diélectriques (3b) nanoporeux, sans molécule active du point de vue rédox, et une pluralité de diélectriques (3a) nanoporeux, ayant une molécule active du point de vue rédox, la molécule active du point de vue rédox pouvant être oxydée et réduite réversiblement, exclusivement entre ses deux états d'oxydation suivant une réaction A ↔ B.

10. Réseau de mémoire WORM suivant l'une des revendications 7 ou 8 précédentes,
**caractérisé par**
une pluralité de diélectriques (3a) nanoporeux, ayant une molécule active du point de vue rédox, la molécule active du point de vue rédox pouvant être oxydée et réduite réversiblement entre ses deux états A et B d'oxydation suivant une première réaction A ↔ B, et dans lequel la molécule active du point de vue rédox a, en outre, au moins un autre état d'oxydation irréversible suivant une deuxième réaction B → C irréversible et/ou suivant une troisième réaction A → D irréversible.

11. Réseau de mémoire RW suivant l'une des revendications 7 ou 8 précédentes,
**caractérisé par**
une pluralité de diélectriques (3a) nanoporeux, ayant une molécule active du point de vue rédox, la molécule active du point de vue rédox pouvant être oxydée et réduite réversiblement entre ses deux états A et B d'oxydation suivant une première réaction A ↔ B, et dans lequel la molécule active du point de vue rédox a, en outre, au moins un autre état d'oxydation réversible suivant une deuxième réaction B ↔ C réversible et/ou suivant une troisième réaction A ↔ D réversible.

12. Utilisation d'un réseau de mémoire ROM suivant la revendication 9,
dans laquelle la molécule active du point de vue rédox est oxydée et réduite réversiblement suivant la réaction A ↔ B par application d'une tension aux électrodes avec un potentiel de lecture au-dessus et en dessous du potentiel normal de la molécule active du point de vue rédox, et le courant mesuré, si une valeur de seuil est dépassée, est lu comme état « 1 », et dans lequel l'état 0 est lu pour des cellules de mémoire sans molécule active du point de vue rédox.

13. Utilisation d'un réseau de mémoire WORM suivant la revendication 10,
dans laquelle la molécule active du point de vue rédox est oxydée et réduite réversiblement suivant la réaction A ↔ B par application d'une tension aux électrodes avec un potentiel de lecture au-dessus et en dessous du potentiel normal de la molécule active du point de vue r'dox et le courant mesuré, si une valeur de seuil est dépassée, est lu comme état 1.

14. Utilisation d'un réseau de mémoire WORM suivant la revendication précédentes,
dans laquelle la molécule active du point de vue rédox est, par application d'une tension aux électrodes avec un potentiel d'écriture, transcrite dans l'état d'oxydation irréversible suivant la revendication B → C ou A → D, de sorte que la molécule active du point de vue rédox ne s'oxyde plus ou ne se réduit plus suivant la réaction A ↔ B par application d'une tension aux électrodes avec un potentiel de lecture au-dessus et en dessous du potentiel normal de la molécule active du point de vue rédox et le courant mesuré est lu comme état 0.

15. Utilisation d'un réseau de mémoire RW suivant la revendication 11,
dans laquelle la molécule active du point de vue rédox est oxydée et réduite réversiblement suivant la réaction A ↔ B par application d'une tension aux électrodes avec un potentiel de lecture au-dessus et en dessous du potentiel normal de la molécule active du point de vue rédox, et le courant mesuré, si une valeur de seuil est dépassée, est lu comme état 1.

16. Utilisation d'un réseau de mémoire RW suivant la revendication précédente,
dans laquelle la molécule active du point de vue rédox est transcrite dans l'état d'oxydation réversible suivant la réaction B ↔ C ou A ↔ D par application d'une tension aux électrodes avec un potentiel d'écriture, de manière à ce que la molécule active du point de vue rédox ne soit plus oxydée ou ne soit plus réduite suivant la réaction A ↔ B par application d'une tension aux électrodes avec un potentiel de lecture au-dessus et en dessous du potentiel normal de la molécule active du point de vue rédox et le courant mesuré est lu comme état 0.

17. Utilisation d'un réseau de mémoire RW suivant les deux revendications précédentes,
**caractérisée par**
la molécule active du point de vue rédox est transcrite dans l'état d'oxydation réversible suivant la réaction A ↔ B par application d'une tension aux électrodes, de manière à ce que la molécule active du point de vue rédox puisse être oxydée et réduite réversiblement à nouveau suivant la réaction A ↔ B par application d'une tension aux électrodes avec un potentiel de lecture au-dessus et en dessous du potentiel normal de la molécule active du point de vue rédox et le courant mesuré est lu, si la valeur de seuil est dépassée, comme état 1.

18. Utilisation d'un réseau de mémoire suivant l'une des revendications 12 à 17 précédentes,
**caractérisée en ce que**
pour un réseau de mémoire ROM, il est mis à disposition une pluralité de cellules de mémoire ayant des concentrations différentes de molécules actives du point de vue rédox dans les diélectriques et elles fonctionnent par l'intermédiaire d'électrodes par des potentiels de lecture et le courant mesuré, si la valeur de seuil est dépassée, est associé à des états de mémoire différents correspondants aux concentrations, et pour un réseau de mémoire RW et un réseau de mémoire WORM, une pluralité de cellules de mémoire, ayant des concentrations différentes en molécules actives du point de vue rédox dans les diélectriques, sont produites réversiblement (RW) ou irréversiblement (WORM) par des potentiels de lecture, et les électrodes fonctionnent par des potentiels de lecture et le courant mesuré est associé à des états de mémoire différents si la valeur de seuil est dépassée.
